# EUROPEAN PATENT APPLICATION

(11) **EP 0 710 993 A1**
(43) Date of publication of application: **08.05.1996**
(21) Application number: 95117425.9
(22) Date of filing: 06.11.1995
(51) Int. Cl.: H01L 39/24

(54) **Oxide system superconducting tape-shaped wire and method of manufacturing the same**

(30) Priority: 07.11.1994 JP 272009/94; 26.04.1995 JP 101886/95
(71) Applicant: HITACHI, LTD., Chiyoda-ku, Tokyo 101 (JP)
(72) Inventor: Okada, Michiya, Mito-shi, Ibaraki 311-11 (JP); Tanaka, Kazuhide, Hitachi-shi, Ibaraki 319-12 (JP); Fukushima, Keiji, Hitachi-shi, Ibaraki 316 (JP)
(74) Representative: Patentanwälte Beetz - Timpe - Siegfried Schmitt-Fumian - Mayr

(57) **Abstract**

In an oxide system superconducting tape-shaped wire (7) long enough for practical application, a compressing process step is performed before a partial melting process step. The density of an oxide system superconductor (1) of the super-conducting tape-shaped wire (7) is heightened more than 90 % of the theoretical density. It is possible to manufacture the superconducting tape-shaped wire (7) long enough for practical application and an oxide system superconducting magnet having 5 T class can be obtained. The superconducting tape-shaped wire (7) has the performance during the magnetic field similarly to the performance of a short sample wire.

## Description

### Background of the Invention:

### Technical Field of the Invention

The present invention relates to an oxide system superconducting tape-shaped wire long enough for practical application and a method of manufacturing the same for supplying the application of the oxide system superconducting tape-shaped wire.

The present invention particularly relates to an oxide system superconducting tape-shaped wire for use in case of a machinery and apparatus construction having a transport current more than 100 A by utilizing the superconducting phenomenon of an oxide system superconductor in mainly in an industrial field of a coil form oxide system superconducting tape-shaped wire which necessities generation of the high magnetic field of more than 5 T.

The above stated industrial field comprising the coil form oxide system superconducting tape-shaped wire has, for example, a machinery and apparatus construction such as a superconducting energy storage system, a superconducting generator, a nuclear fusion superconducting magnet, an accelerator, a NMR analyzer, a medical use MRI apparatus, and a current lead etc..

### Prior Arts

An oxide system superconductor has following features by comparing with a conventional metal system superconductor.
(1) The superconducting transition temperature is high and has 40-150 K.
(2) The critical magnetic field is about 100 T degree or is excessively large more than the above value.
(3) The transport critical current density has an order of 1,000 A/mm² at maximum.
(4) The deformation processing is difficult due to the ceramics material.
(5) The crystal has the anisotropic property, the current easily flows toward a axial direction and b axial direction of the crystal but the current flown toward c axial direction is low and has the value of 1/10 - 1/100 of the above stated currents.
(6) The critical magnetic field has the anisotropic property, in particularly, when the magnetic field is applied to c axial direction of the crystal, the irreversible critical magnetic field relating to the current transportation is 1/10 - 1/100 by comparing with a case when the magnetic field is applied toward a axial direction or b axial direction.

An attempt for applying the oxide system superconductor having the above stated characteristics to the superconducting magnet is disclosed on a document "Proceedings of the Force International Symposium on Superconductivity" (ISS 91), 1991, November, pages 547-552.

Since both the critical temperature and the critical magnetic field of the oxide system superconductor are high widely different by comparing with the metal system superconductor, when the oxide system superconductor is applied for use in the superconducting magnet field, there is a remarkable merit in which an extremely stable system having no quenching trouble can be constituted.

Further, since the critical temperature of the oxide system superconductor is high, it is no necessity in which the liquid helium is used as the conventional cooling medium. However, it is enable to utilize the cooling medium means such as the refrigerator and the liquid nitrogen etc..

Besides, in the superconducting magnet using the oxide system superconductor having developed until now, the generation magnet field is about 1-3 T degree even at the highest performance liquid helium temperature (4.2 K).

As disclosed in a document "Cryogenics Engineering", volume 28, No. 5, 1993, pages 29-49, the generation magnetic field in the conventional metal system superconducting magnet is 20 T degree.

In comparison with the generation magnetic field of the metal system superconducting magnet, the generation magnetic field of the oxide system superconductor is low and has a number of a figure under the existing circumstances.

A basic process for obtaining a high performance in the superconducting wire long enough for practical application is disclosed in, for example Japanese patent laid-open No. Hei 4-79,107, Japanese patent laid-open No. Hei 4-79,109, Japanese patent laid-open No. Hei 4-131,122 and Japanese patent laid-open No. Hei 4-70,701 etc..

However, in the already known conventional methods, it is difficult to sufficiently attain the improvement in the transport current of the oxide system superconducting tape-shaped wire long enough for practical application and further it is necessary to study the manufacture condition and the manufacture apparatus of the superconducting tape-shaped wire in detail.

A first problem in the existing circumstances resides in that the generation magnetic field of the superconducting coil in 4.2 K is 1-3 T degree at the highest and this value is still small for use in practice.

So as to obtain the full-scale industrial application, it is necessary to heighten the performance of the oxide system superconducting tape-shaped wire for use in the superconducting coil.

Further, it is necessary to complete a technique for enable to manufacture the superconducting magnet in which the generation magnetic field can produce 5 T class at the minimum.

Herein, the most important problem is that an industrial means has not established until now, such an industrial means is how the high performance in the transport current on the already known short sample wire of the oxide system superconducting wire can be attained in the long size oxide system superconducting tape-shaped wire long enough for practical application which enable to constitute the superconducting coil.

In actually, when the performance of the already known short sample superconducting wire is realized in the oxide system superconducting wire long enough for practical application as it is, it is natural that the generation magnetic field of 5-10 T degree for easily enable to utilizing as the industrial material realizes.

However, in the conventional techniques, there is no report in which, by using the superconducting coil prepared by applying the oxide system superconductive tape-shaped wire, the magnetic energy can be stored by the persistent current.

This reason is a fact in which the critical current performance of the superconducting portion in the superconducting wire is not sufficiently high so as to realize the persistent current.

The above causes are derived from, in the manufacture process the oxide system superconducting tape-shaped wire long enough for practical application, the process for compressing process the oxide system superconductor is not to perform the optimum.

So as to widely apply the oxide system superconductor in the industry field, it is necessary to enable to generate the magnetic field of more than 5 T at the lowermost and further, preferably, to establish the manufacture technique of the oxide system superconducting wire long enough for practical application enabling the operation by the persistent current.

### Summary of the Invention:

An object of the present invention is to provide an oxide system superconducting tape-shaped wire and a method of manufacturing the same wherein performance in an oxide system superconducting tape-shaped wire for practical application can be obtained so as to have similar performance in a short sample superconducting tape-shaped wire during the magnetic field generation.

Another object of the present invention is to provide an oxide system superconducting tape-shaped wire and a method of manufacturing the same wherein the high transport current value in an oxide system superconducting tape-shaped wire for practical application can be obtained so as to have the similar transport current value in a short sample superconducting tape-shaped wire.

A further object of the present invention is to provide an oxide system superconducting tape-shaped wire and a method of manufacturing the same wherein the compressive composition of a superconductor in an oxide system superconducting taped shaped wire for practical application can be obtained.

A further object of the present invention is to provide an oxide system superconducting tape-shaped wire and a method of manufacturing the same wherein the critical temperature performance in the oxide system superconducting tape-shaped wire long enough for practical application can be heightened and the critical current density can be homogenized.

A further object of the present invention is to provide an oxide system superconducting tape-shaped wire and a method of manufacturing the same wherein the effects for remarkably improving the homogeneity property and the absolute value of the critical current density in the oxide system superconducting tape-shaped wire long enough for practical application can be attained.

The persistent current magnet for enable to generate 5 T class is realized by heightening the critical current density of the superconducting tape-shaped wire in the above stated oxide system superconducting wire long enough for practical application to the substantial equal level of the short sample superconducting wire.

Means for realizing the persistent current magnet having the above stated performance is attained by a following means.

Namely, it can be attained by, in the oxide system superconducting tape-shaped wire having the flat cross-sectional shape and also covered by the metal, and in the lateral direction cross-section and the longitudinal direction cross-section after the compressing processing of the superconducting wire, the boundary face of the metal covering member and the oxide system superconductor portion is substantially smooth and also the density of the oxide system superconductor is more than 90 % of the theoretical density.

Further, it can be attained by, in the manufacture method of the oxide system superconducting tape-shaped wire having the flat cross-sectional shape and also covered by the metal, after the superconducting wire has processed to form at a predetermined shape, and after the superconducting wire is compressively processed more than 90 % of the theoretical density, further the superconducting wire is partially molten.

Further, it can be attained by, in the manufacture method of the oxide system superconducting tape-shaped wire, in the compressing process the drawing process apparatus is employed.

Namely, the manufacture method using the drawing process apparatus comprises a step of continuously inserting the superconducting wire between the horizontal face of the disk and the face of the roll. The above disk is arranged at the lower portion and can rotate in the horizontal direction and the above roll is arranged at the upper portion and can rotate in the vertical direction.

The above drawing process apparatus is enable to statically pressurize by the pressuring force of more than 1 ton against the vertical axis between the upper roll portion and the disk and further the diameter of the upper roller is more than 200 mm.

Further, it can be attained by, in the manufacture method of the oxide system superconducting tape-shaped wire, in the compressing process, it is constituted by a pair of rotative shafts arranged in parallel and a pair of the rolls rotatively arranged with the pair of the rotative shafts.

The manufacture steps comprise by a step of tilting or sloping with a constant angle the processed face sandwiched superconductive wire of the pair of rolls against the rotative shafts and between the upper roll and the lower roll, and a step of continuously pressurizing the superconducting wire with the pressuring force of more than 1 ton against the vertical axis, and further the minimum portion of the diameter of the roll is more than 200 mm.

Further, it can be attained by, in the manufacture method of the oxide system superconducting tape-shaped wire, at the compressing process using the manufacture apparatus of the superconducting tape-shaped wire in which the moving superconductive wire is repeatedly pressed under pressure by the arc-shaped face of the arc-shaped depressor tool. This arc-shaped depressor tool has the outwardly projected arc-shaped portion and is arranged at the upper portion.

The superconducting tape-shaped wire manufacture apparatus constitutes that the face of another tool arranged at the lower portion and opposed arranged against the arc-shaped depressor tool is the flat face and also the superconducting wire is enable to be pressurized the pressuring force of more than 1 ton against the vertical axis by the arc-shaped depressor tool.

Further, the arc diameter of the arc-shaped depressor tool is more than 200 mm. It can be attained by, any one of the disk, the roll and the arc-shaped depressor tool is constituted by the hard metal alloy.

Further, it can be attained by, in the compressing process in the oxide system superconducting tape-shaped wire, the process comprises the process for reducing the diameter of the circle cross-sectional shape superconducting wire to the radius (r) and the process for processing the superconducting wire at the flat shape having the width (w) and thereby the ratio (w/2r) is more than 3 but less than 6.

Further, it can be attained by, in the compressing process, by adding the tension to the outlet side of the continuously discharged superconducting tape-shaped wire, the meandering of the superconducting wire is restrained.

Further, it can be attained by, in the compressing process, using the multifilament superconducting wire having the circle cross-section as the superconducting wire and at the inlet side to which the superconducting wire is continuously inserted, by adding the rotation operation to the superconducting wire, the twist construction is added to the superconducting wire having the flat cross-section.

Further, it can be attained by, in the oxide system superconducting tape-shaped wire, the superconducting wire has the flat shape and also each of plural superconductors arranged in the cross-section of the superconducting wire is covered by the metal, the total sum of the thicknesses of the superconductors is more than 20 % but less than 80 % of the whole thickness of the superconducting wire.

Further, it can be attained by, in the process of the superconducting wire, during the circle cross-section shape superconducting wire, after the superconducting wire is suitably heated according to the heat treatment during about more than 1 hour and at 800 °C, the superconducting wire is performed to the rapid cooling and is processed to form the flat cross-section shape. Thereby, the swelling in the superconducting wire due to the generation gas at the final heat treatment is prevented.

Further, it can be attained by, in the manufacture method of the oxide system superconducting tape-shaped wire, after the partial melting heat treatment, the heat treatment is performed under the conditions of the mixture gas atmosphere having 1-10 % oxygen and nitrogen and the inert gas, at 400-900 °C and during 1-300 hours.

Further, it can be attained by, in the partial melting heat treatment method and the heat treatment process of the oxide system superconducting tape-shaped wire, the error in temperature during the heat treatment is less than 1 °C.

Further, it can be attained by, in the manufacture method of the multifilament superconducting wire, the particle size (L) of the powder crystal for packing up to the metal pipe having the initial period outer diameter being processed to form the flat shape is L < t/2 with the thickness (t) of each core of the multifilament superconducting wire after the final processing, and the particle size (L) of the crystal is at least more than 0.1 µm.

Further, it can be attained by, in the superconducting coil comprised of the oxide system superconducting tape-shaped wire and the insulating tape-shaped wire wound in the coil form and the persistent current switch, the mechanical strength of the insulating member has the strength enough for functioning as the reinforcement member in comparison with the mechanical strength of the superconducting wire.

Further, it can be attained by, in the superconducting coil comprised of the oxide system superconducting tape-shaped wire and the insulating tape-shaped wire wound in the coil form and the persistent current switch, the electrical resistances at the both ends of the superconducting coil are low so as to function to a certain degree as the persistent current magnet.

Further, it can be attained by, in the oxide system superconducting tape-shaped wire, the oxide system superconductor comprises of Bi system superconductor or Tl system superconductor.

Further, it can be attained by, in the oxide system superconducting tape-shaped wire, the metal covering member is selected one from the groups of Ag or Au, the alloy of one kind or two kinds of Ag and Au as the base member, Ag alloy or Au alloy containing the very small quantity of Mg, Ti, Ni and Cu as the additive substance.

Further, it can be attained by, in the oxide system superconducting tape-shaped wire, the alloy is employed one kind or more than two kinds selected from Cu alloy containing 2-12 % Al as the insulating member, stainless steel, Ti alloy, Fe base heat-resistance alloy, Ni base heat-resistance alloy, and Co base heat-resistance alloy.

Further, it can be attained by, in the manufacture method of the oxide system superconducting magnet, before the coil winding process, the insulating metal member is performed to the heat treatment in advance, after the oxide film is formed on the surface of the insulating metal member, the insulating metal member is wound in coil form.

Further, it can be attained by, in the manufacture method of the oxide system superconducting magnet, after the coil winding process, the insulating metal member is performed to the heat treatment.

The persistent current magnet for enable to generate 5 T class is realized by heightening the critical current density of the superconducting wire in the oxide system superconducting tape-shaped wire long enough for practical application to have the substantial equal level of the critical current density of the short sample superconducting wire.

It can be attained by, in the oxide system superconducting tape-shaped wire having the flat cross-sectional shape and also covered by the metal, and in the lateral direction cross-section and the longitudinal direction cross-section after the compressing process of the superconducting wire, the boundary face of the metal covering member and the oxide system superconductor portion are substantially smooth and also the density of the oxide superconductor is more than 90 % of the theoretical density.

Further, it can be attained by, in the manufacture method of the oxide system superconducting tape-shaped wire, after the superconducting wire has processed to have at a predetermined shape, and after the superconducting wire is compressively processed more than 90 % of the theoretical density, after that the superconducting wire is partially molten.

Herein, the partial melting heat treatment increases a contacting area between the crystal particles in the already known oxide system superconductor and heightens the superconductivity joining property.

The inventors of the present invention diligently studied the research and found out a following fact. Such a fact is that so as to obtain the high transport current ability in the oxide system superconducting tape-shaped wire long enough for practical application, in the oxide system superconducting tape-shaped wire having the flat cross-section shape and covered by the metal, it necessities to perform the following process.

The above stated process is that in both the lateral direction cross-section and the longitudinal direction cross-section of the superconducting wire after the compressing process of the superconducting wire, even after this process, the boundary face of the metal covering member and the oxide system superconductor portion is substantially maintained to form the flat face and the density of the oxide system superconductor is compressed to have the theoretical density of more than 90 %.

After the above stated process, the partial melting treatment process is performed and the orientation property, the phase shift generated during the partial melting treatment and the scattering of voids are attained on a whole oxide system superconducting tape-shaped wire long enough for practical application.

Further, the effects for remarkably improving the homogeneity property and the absolute value of the critical current density in the oxide system superconducting tape-shaped wire long enough for practical application can be found.

Further, in the compressing process in the manufacture method of the oxide system superconducting tape-shaped wire, a drawing processing apparatus can be employed. The drawing processing apparatus comprises a rotating disk which is disposed toward a lower portion and rotates in a horizontal direction and a roll which is disposed toward an upper portion and rotates in a vertical direction.

In this compressing process apparatus the oxide system superconducting tape-shaped wire is continuously inserted into between the disk and the roll.

Further another drawing processing apparatus can be employed. Such a drawing processing apparatus comprises a pair of rotative shafts disposed in parallel and a pair of rolls rotatively with the pair of rotative shafts, the above pair of rolls comprise an upper portion roll and a lower portion roll.

In this drawing processing apparatus, the faces of the pair of rolls for sandwiching the superconducting wire by the pair of rolls are tilted or sloped with a predetermined angle against the rotative shafts.

Further, a further drawing processing apparatus can be employed. Such a drawing processing apparatus comprises an arc-shaped depressor tool disposed at an upper portion and having an outside projected arc-shaped face and another tool oppositely disposed against the arc-shaped depressor tool having a flat face. In this drawing processing apparatus, the moving superconducting wire is repeatedly depressed by the arc-shaped face of the arc-shaped depressor tool.

In the above various drawing processing apparatuses the superconducting wire is statically pressurized under the pressurizing force having more than 1 ton against the upper and lower direction (the vertical axis), and the upper roll (or the arc-shaped tool) having the diameter of more than 200 mm rotates and continuously prepares the superconducting wire. With the above stated drawing processing apparatuses, the concrete means for continuously compressing the superconducting wire can be established.

Herein, in both the lateral direction cross-section and the longitudinal direction cross-section of the oxide system superconducting tape-shaped wire after the compressing process, by substantially flatly maintaining the boundary face of the metal covering member and the oxide system superconductor portion so as to obtain the sufficient compression degree, using the above stated compressing process apparatus, it is necessary to obtain the pressuring force of more than 1 ton, preferably more than 2 tons per unit area (cm²).

Further, the roll construction is like the above, it is possible to constitute the compressing process having the intermediate property of the common pressing and the pressing process for the flat plate.

Herein, it is necessary to have the roll diameter (the arc diameter) of more than 60 mm at the utmost. When the roll diameter (the arc diameter) is smaller than the above, it is impossible to substantially flatly maintain the boundary face between the metal covering member and the oxide system superconductor portion in the length direction of the superconducting wire, thereby it does not effectively operate as the means for continuous compressing.

So as to obtain the oxide system superconducting tape-shaped wire having the stable and high performance long enough for practical application, preferably, it necessities the roll diameter (the arc diameter) having more than 200 mm.

Further, in the compressing process of the superconducting wire, after the size compression process having the circle cross-section shape to the radius (r), when the superconducting wire is processed to form the flat tape shape having width (w), it is necessary to make the ratio (w/2r) of more than 3 but less than 6.

As a result, in the width direction of the superconducting wire, by substantially smoothly maintain the boundary face between the metal covering member and the superconductor portion, the density of the oxide system superconductor is heightened, thereby it is possible to attain the oxide system superconducting tape-shaped wire long enough for practical application.

Further, in the subsequent partial melting heat treatment, it is possible to obtain the high critical current density Jc having more than 1,000 A/mm².

Further, since the material of the disk, the roll portion, and the arc-shaped tool is constituted of the hard metal alloy, the pressurization accompanying with the smooth cross-section can be attained without the deformation of the roll.

Further, in the compressing process, by adding the tension at the outlet side of the superconducting tape-shaped wire being continuously discharged, the meandering of the superconducting wire can be effectively restrained.

This tension is the necessary means in the pressurizing apparatus, and in case that the tension means is not employed, there is an afraid that the superconducting wire may meander or bent.

Further, in the compressing process, the multifilament superconducting wire having the circle cross-section is employed as the superconducting wire and at the inlet side in which the superconducting wire is continuously inserted the rotation operation is given to the superconducting wire.

Since the twist construction is given to the superconducting wire having the flat cross-section, a following effect causes. Namely, the alternative current generated in the superconductor during the excitation can be reduced.

In this case, preferably, when the drawing tool being constituted by the disk disposed at the lower portion is used, it is desirable to consistent the peripheral speed of the disk with the rotation speed of the superconducting wire.

Further, in the oxide system superconducting tape-shaped wire, the superconducting wire has the flat cross-section shape, each of the plural superconductors disposed in the cross-section of the superconducting wire is covered by the metal and the total in thickness of the superconductors is more than 20 % but less than 80 % of the whole thickness of the superconducting wire. Thereby, in the process according to the present invention the oxide system superconducting tape-shaped wire long enough for practical application can be stably prepared.

Further, in the compressing process of the superconducting tape-shaped wire, during the superconducting wire having the circle cross-section, after the heat treatment during approximately more than 1 hour and at about 800 °C, the rapid cooling is performed.

Thereby, the swelling in the superconducting tape-shaped wire due to generation gas in the final heat treatment and the inferior in performance of the oxide system superconducting tape-shaped wire long enough for practical application can be prevented.

Further, in the manufacture method of the oxide system superconducting tape-shaped wire, after the partial melting process, the heat treatment is performed under conditions of the mixture gas atmosphere of 1-10 % oxygen and nitrogen or the inert gas, at 400-900 °C, and during 1-300 hours.

Thereby, the critical temperature performance in the oxide system superconducting tape-shaped wire long enough for practical application can be heightened, and the critical current density Jc can be homogenized.

Further, when Bi system superconductor of the superconducting wire is employed, the remarkable effect can be obtained.

Further, in the partial melting treatment process and the heat treatment process of the oxide system superconducting tape-shaped wire, since the error in temperature during the heat treatment has less than 1 C, the distribution of the critical current performance of the oxide system superconducting tape-shaped wire long enough for practical application can be restrained with less than 10 %.

This is the necessary process for maintaining the homogenous of the critical current performance of the oxide system superconducting tape-shaped wire long enough for practical application.

Thereby, in the oxide system superconducting tape-shaped wire long enough for practical application, in particularly in the multifilament superconducting wire having the thin core cross-section, it is possible to remarkably heighten the smoothing property between the core and the metal covering member, the orientation property along to the whole length of the oxide system superconducting tape-shaped wire can be heightened and the performance can be homogenized.

Further, in the superconducting coil having the oxide system superconducting tape-shaped wire and the insulating tape-shaped wire being wound with the coil form and the persistent current switch, since the mechanical strength of the insulating member has strength enough for functioning as the reinforcement member in comparison with the strength of the superconducting tape-shaped wire, the superconducting magnet enable to bear the magnetic force during the high magnetic field can be constituted, thereby the persistent current coil can be realized.

Further, in the superconducting magnet having the oxide system superconducting tape-shaped wire and the insulating tape-shaped wire being wound with the coil form and the persistent current switch, the electric resistances at both sides of the superconducting magnet are constituted to be low enough for functioning as the persistent current switch, the persistent current coil can be realized.

Further, in the oxide system superconducting tape-shaped wire, as the oxide system superconductor it is preferable to select Bi system or Tl system superconductor, however the following already known superconductor material can be selected, for example.

### Tl-Ba-Ca-Cu-O system:

Tl_{1.5-2.2}-Ba_{1.5-2.2}-Cu_{0.5-1.3}-O₅₋₇
Tl_{1.5-2.2}-Ba_{1.5-2.2}-Ca_{0.5-1.3}-Cu_{1.5-2.3}-O₇₋₉
Tl_{1.5-2.2}-Ba_{1.5-2.3}-Ca_{1.5-2.3}-Cu_{2.5-2.3}-O₉₋₁₁
Tl_{0.5-1.2}-Ba_{1.5-2.2}-Cu_{0.5-1.3}-O₄₋₆
Tl_{0.5-1.2}-Ba_{1.5-2.2}-Ca_{0.5-1.2}-Cu_{1.5-2.3}-O₆₋₈
Tl_{0.5-1.2}-Ba_{1.5-2.2}-Ca_{2.5-3.2}-Cu_{3.5-4.3}-O₈₋₁₀

### Tl-Sr-Ca-Cu-O system:

Tl_{1.5-2.2}-Sr_{1.5-2.2}-Cu_{0.5-1.3}-O₅₋₇
Tl_{1.5-2.2}-Sr_{1.5-2.2}-Ca_{0.5-1.3}-Cu_{1.5-2.3}-O₇₋₉
Tl_{1.5-2.2}-Sr_{1.5-2.2}-Ca_{0.5-1.3}-Cu_{2.5-3.3}-O₉₋₁₁
Tl_{0.5-1.2}-Ba_{1.5-2.3}-Cu_{0.5-1.3}-O₄₋₆
Tl_{0.5-1.2}-Sr_{1.5-2.2}-Ca_{0.5-1.2}-Cu_{1.5-2.3}-O₆₋₈
Tl_{0.5-1.2}-Sr_{1.5-2.2}-Ca_{2.5-3.2}-Cu_{3.5-4.3}-O₈₋₁₀

### Tl-Ba-Sr-Ca-Cu-O system:

Tl_{1.5-2.2}-(Baₓ,Sr₁₋ₓ)_{1.5-2.2}-Cu_{0.5-1.3}-O₅₋₇
Tl_{1.5-2.2}-(Baₓ,Sr₁₋ₓ)_{1.5-2.2}-Ca_{0.5-1.3}-Cu_{1.5-2.3}-O₇₋₉
Tl_{1.5-2.2}-(Baₓ,Sr₁₋ₓ)_{1.5-2.2}-Ca_{1.5-2.3}-Cu_{2.5-3.3}-O₉₋₁₁
Tl_{0.5-1.2}-(Baₓ,Sr₁₋ₓ)_{1.5-2.2}-Cu_{0.5-1.3}-O₄₋₆
Tl_{0.5-1.2}-(Baₓ,Sr₁₋ₓ)_{1.5-2.2}-Ca_{0.5-1.2}-Cu_{1.5-2.3}-O₆₋₈
Tl_{0.5-1.2}-(Baₓ,Sr₁₋ₓ)_{1.5-2.2}-Ca_{2.5-3.2}-Cu_{3.5-4.3}-O₈₋₁₀
wherein, x = 0.1-0.9

### Tl-Pb-Sr-Ca-Cu-O system:

(Tl_{y},Pb_{1-y})_{1.5-2.2},Sr_{1.5-2.2}-Cu_{0.5-1.3}-O₅₋₇
(Tl_{y},Pb_{1-y})_{1.5-2.2},Sr_{1.5-2.2}-Ca_{0.5-1.3}-Cu_{1.5-2.3}-O₇₋₉
(Tl_{y},Pb_{1-y})_{1.5-2.2},Sr_{1.5-2.3}-Ca_{1.5-2.3}-Cu_{2.5-2.3}-O₉₋₁₁
(Tl_{y},Pb_{1-y})_{0.5-1.2},Ba_{1.5-2.2}-Cu_{0.5-1.3}-O₄₋₆
(Tl_{y},Pb_{1-y})_{0.5-1.2},Sr_{1.5-2.2}-Ca_{0.5-1.2}-Cu_{1.5-2.3}-O₆₋₈
(Tl_{y},Pb_{1-y})_{0.5-1.2},Sr_{1.5-2.2}-Ca_{2.5-3.2}-Cu_{3.5-4.3}-O₈₋₁₀
wherein, y = 0.1-0.9

### Tl-Pb-Ba-Sr-Ca-Cu-O system:

(Tl_{y,}Pb_{1-y})_{1.5-2.2}-(Baₓ,Sr₁₋ₓ)_{1.5-2.2}-Cu_{0.5-1.3}-O₅₋₇
(Tl_{y},Pb_{1-y})_{1.5-2.2}-(Baₓ,Sr₁₋ₓ)_{1.5-2.2}-Ca_{0.5-1.3}-Cu_{1.5-2.3}-O₇₋₉
(Tl_{y},Pb_{1-y})_{1.5-2.2}-(Baₓ,Sr₁₋ₓ)_{1.5-2.3}-Ca_{1.5-2.3}-Cu_{2.5-2.3}-O₉₋₁₁
(Tl_{y},Pb_{1-y})_{0.5-1.2}-(Baₓ,Sr₁₋ₓ)_{1.5-2.2}-Cu_{0.5-1.3}-O₄₋₆
(Tl_{y},Pb_{1-y})_{0.5-1.2}-(Baₓ,Sr₁₋ₓ)_{1.5-2.2}-Ca_{0.5-1.2}-Cu_{1.5-2.3}-O₆₋₈
(Tl_{y},Pb_{1-y})_{0.5-1.2}-(Baₓ,Sr₁₋ₓ)_{1.5-2.2}-Ca_{2.5-3.2}-Cu_{3.5-4.3}-O₈₋₁₀
wherein, x = 0.1-0.9, y = 0.1-0.9

### Bi-Sr-Ca-Cu-O system:

Bi_{1.5-2.2}-Sr_{1.5-2.2}-Cu_{0.5-1.3}-O₅₋₇
Bi_{1.5-2.2}-Sr_{1.5-2.2}-Ca_{0.5-1.3}-Cu_{1.5-2.3}-O₇₋₉
Bi_{1.5-2.2}-Sr_{1.5-2.2}-Ca_{0.5-1.3}-Cu_{2.5-3.3}-O₉₋₁₁

### Bi-Pb-Sr-Ca-Cu-O system:

(Bi_{y},Pb_{1-y})_{1.5-2.2}-Sr_{1.5-2.2}-Cu_{0.5-1.3}-O₅₋₇
(Bi_{y},Pb_{1-y})_{1.5-2.2}-Sr_{1.5-2.2}-Ca_{0.5-1.3}-Cu_{1.5-2.3}-O₇₋₉
(Bi_{y},Pb_{1-y})_{1.5-2.2}-Sr_{1.5-2.2}-Ca_{1.5-2.3}-Cu_{2.5-3.3}-O₉₋₁₁
wherein, y = 0.1-0.9

### Ln-Ba-Cu-O system:

Ln_{1.5-2.3}-Cu_{0.5-1.3}-O₄₋₆
Ln_{0.5-1.3}-Ba_{1.5-2.3}-Cu_{2.5-3.3}-O₆₋₈
- Ln :: Y, Sc, La, Ac, Ce, Pr, Nd, Pm, Sm, Eu, Gd, Tb, Dy, Ho, Er, Tm, Yb, Lu

### Ln-Sr-Cu-O system:

Ln_{0.5-1.3}-Sr_{1.5-2.3}-Cu_{2.5-3.3}-O₆₋₈
- Ln :: Y, Sc, La, Ac, Ce, Pr, Nd, Pm, Sm, Eu, Gd, Tb, Dy, Ho, Er, Tm, Yb, Lu

### Bi-Sr-Y-Cu-O system:

(Bi₁₋ₓ,Cuₓ)-Sr₂-(Y_{1-y},Cu_{y})-Cu₂-O₆₋₈
wherein, x = 0.1-0.9, y = 0.1-0.9

### Ba-Ca-Cu-O system:

Cu_{0.5-1.2}-Ba_{1.5-2.2}-Cu_{0.5-1.3}-O₄₋₆
Cu_{0.5-1.2}-Ba_{1.5-2.2}-Ca_{0.5-1.2}-Cu_{1.5-2.3}-O₆₋₈
Cu_{0.5-1.2}-Ba_{1.5-2.2}-Ca_{2.5-3.2}-Cu_{3.5-4.3}-O₈₋₁₀
(Agₓ,Cu₁₋ₓ)_{0.5-1.2}-Ba_{1.5-2.2}-Cu_{0.5-1.3}-O₄₋₆
(Agₓ,Cu₁₋ₓ)_{0.5-1.2}-Ba_{1.5-2.2}-Ca_{0.5-1.2}-Cu_{1.5-2.3}-O₆₋₈
(Agₓ,Cu₁₋ₓ)_{0.5-1.2}-Ba_{1.5-2.2}-Ca_{2.5-3.2}-Cu_{3.5-4.3}-O₈₋₁₀
wherein, x = 0-1

### Sr-Ca-Cu-O system:

Cu_{0.5-1.2}-Sr_{1.5-2.2}-Cu_{0.5-1.3}-O₄₋₆
Cu_{0.5-1.2}-Sr_{1.5-2.2}-Ca_{0.5-1.2}-Cu_{1.5-2.3}-O₆₋₈
Cu_{0.5-1.2}-Sr_{1.5-2.2}-Ca_{2.5-3.2}-Cu_{3.5-4.3}-O₈₋₁₀
(Agₓ,Cu₁₋ₓ)_{0.5-1.2}-Sr_{1.5-2.2}-Cu_{0.5-1.3}-O₄₋₆
(Agₓ,Cu₁₋ₓ)_{0.5-1.2}-Sr_{1.5-2.2}-Ca_{0.5-1.2}-Cu_{1.5-2.3}-O₆₋₈
(Agₓ,Cu₁₋ₓ)_{0.5-1.2}-Sr_{1.5-2.2}-Ca_{2.5-3.2}-Cu_{3.5-4.3}-O₈₋₁₀
wherein, x = 0-1

### Hg-Ba-Ca-Cu-O system:

Hg_{1.5-2.2}-Ba_{1.5-2.2}-Cu_{0.5-1.3}-O₅₋₇
Hg_{1.5-2.2}-Ba_{1.5-2.2}-Ca_{0.5-1.3}-Cu_{1.5-2.3}-O₇₋₉
Hg_{1.5-2.2}-Ba_{1.5-2.3}-Ca_{0.5-1.3}-Cu_{2.5-3.3}-O₉₋₁₁
Hg_{0.5-1.2}-Ba_{1.5-2.2}-Cu_{0.5-1.3}-O₄₋₆
Hg_{0.5-1.2}-Ba_{1.5-2.2}-Ca_{0.5-1.2}-Cu_{1.5-2.3}-O₆₋₈
Hg_{0.5-1.2}-Ba_{1.5-2.2}-Ca_{2.5-3.2}-Cu_{3.5-4.3}-O₈₋₁₀

### Hg-Sr-Ca-Cu-O system:

Hg_{1.5-2.2}-Sr_{1.5-2.2}-Cu_{0.5-1.3}-O₅₋₇
Hg_{1.5-2.2}-Sr_{1.5-2.2}-Ca_{0.5-1.3}-Cu_{1.5-2.3}-O₇₋₉
Hg_{1.5-2.2}-Sr_{1.5-2.3}-Ca_{0.5-1.3}-Cu_{2.5-3.3}-O₉₋₁₁
Hg_{0.5-1.2}-Sr_{1.5-2.2}-Cu_{0.5-1.3}-O₄₋₆
Hg_{0.5-1.2}-Sr_{1.5-2.2}-Ca_{0.5-1.2}-Cu_{1.5-2.3}-O₆₋₈
Hg_{0.5-1.2}-Sr_{1.5-2.2}-Ca_{2.5-3.2}-Cu_{3.5-4.3}-O₈₋₁₀

### Hg-Ba-Sr-Ca-Cu-O system:

Hg_{1.5-2.2}-(Baₓ,Sr₁₋ₓ)_{1.5-2.2}-Cu_{0.5-1.3}-O₅₋₇
Hg_{1.5-2.2}-(Baₓ,Sr₁₋ₓ)_{1.5-2.2}-Ca_{0.5-1.3}-Cu_{1.5-2.3}-O₇₋₉
Hg_{1.5-2.2}-(Baₓ,Sr₁₋ₓ)_{1.5-2.3}-Ca_{1.5-2.3}-Cu_{2.5-3.3}-O₉₋₁₁
Hg_{0.5-1.2}-(Baₓ,Sr₁₋ₓ)_{1.5-2.2}-Cu_{0.5-1.3}-O₄₋₆
Hg_{0.5-1.2}-(Baₓ,Sr₁₋ₓ)_{1.5-2.2}-Ca_{0.5-1.2}-Cu_{1.5-2.3}-O₆₋₈
Hg_{0.5-1.2}-(Baₓ,Sr₁₋ₓ)_{1.5-2.2}-Ca_{2.5-3.2}-Cu_{3.5-4.3}-O₈₋₁₀
wherein, x = 0.1-0.9

### Hg-Pb-Sr-Ca-Cu-O system:

(Hg_{y},Pb_{1-y})_{1.5-2.2}-Sr_{1.5-2.2}-Cu_{0.5-1.3}-O₅₋₇
(Hg_{y},Pb_{1-y})_{1.5-2.2}-Sr_{1.5-2.2}-Ca_{0.5-1.3}-Cu_{1.5-2.3}-O₇₋₉
(Hg_{y},Pb_{1-y})_{1.5-2.2}-Sr_{1.5-2.3}-Ca_{1.5-2.3}-Cu_{2.5-3.3}-O₉₋₁₁
(Hg_{y},Pb_{1-y})_{0.5-1.2}-Ba_{1.5-2.2}-Cu_{0.5-1.3}-O₄₋₆
(Hg_{y},Pb_{1-y})_{0.5-1.2}-Sr_{1.5-2.2}-Ca_{0.5-1.2}-Cu_{1.5-2.3}-O₆₋₈
(Hg_{y},Pb_{1-y})_{0.5-1.2}-Sr_{1.5-2.2}-Ca_{2.5-3.2}-Cu_{3.5-4.3}-O₈₋₁₀
wherein, y = 0.1-0.9

### Hg-Pb-Ba-Sr-Ca-Cu-O system:

(Hg_{y},Pb_{1-y})_{1.5-2.2}-(Baₓ,Sr₁₋ₓ)_{1.5-2.2}-Cu_{0.5-1.3}-O₅₋₇
(Hg_{y},Pb_{1-y})_{1.5-2.2}-(Baₓ,Sr₁₋ₓ)_{1.5-2.2}-Ca_{0.5-1.3}-Cu_{1.5-2.3}-O₇₋₉
(Hg_{y},Pb_{1-y})_{1.5-2.2}-(Baₓ,Sr₁₋ₓ)_{1.5-2.3}-Ca_{1.5-2.3}-Cu_{2.5-3.3}-O₉₋₁₁
(Hg_{y},Pb_{1-y})_{0.5-1.2}-(Baₓ,Sr₁₋ₓ)_{1.5-2.2}-Cu_{0.5-1.3}-O₄₋₆
(Hg_{y},Pb_{1-y})_{0.5-1.2}-(Baₓ,Sr₁₋ₓ)_{1.5-2.2}-Ca_{0.5-1.2}-Cu_{1.5-2.3}-O₆₋₈
(Hg_{y},Pb_{1-y})_{0.5-1.2}-(Baₓ,Sr₁₋ₓ)_{1.5-2.2}-Ca_{2.5-3.2}-Cu_{3.5-4.3}-O₈₋₁₀
wherein, x = 0.1-0.9, y = 0.1-0.9

### Hg-TL-Ba-Sr-Ca-O system:

(Hg_{y},Tl_{1-y})_{1.5-2.2}-(Baₓ,Sr₁₋ₓ)_{1.5-2.2}-Cu_{0.5-1.3}-O₅₋₇
(Hg_{y},Tl_{1-y})_{1.5-2.2}-(Baₓ,Sr₁₋ₓ)_{1.5-2.2}-Ca_{0.5-1.3}-Cu_{1.5-2.3}-O₇₋₉
(Hg_{y},Tl_{1-y})_{1.5-2.2}-(Baₓ,Sr₁₋ₓ)_{1.5-2.3}-Ca_{1.5-2.3}-Cu_{2.5-3.3}-O₉₋₁₁
(Hg_{y},Tl_{1-y})_{0.5-1.2}-(Baₓ,Sr₁₋ₓ)_{1.5-2.2}-Cu_{0.5-1.3}-O₄₋₆
(Hg_{y},Tl_{1-y})_{0.5-1.2}-(Baₓ,Sr₁₋ₓ)_{1.5-2.2}-Ca_{0.5-1.2}-Cu_{1.5-2.3}-O₆₋₈
(Hg_{y},Tl_{1-y})_{0.5-1.2}-(Baₓ,Sr₁₋ₓ)_{1.5-2.2}-Ca_{2.5-3.2}-Cu_{3.5-4.3}-O₈₋₁₀
wherein, x = 0-1, y = 0.1-0.9
Further, in the oxide system superconducting tape-shaped wire, the metal covering member comprises Ag or Au, or one kind or two kinds of Ag or Au as the base metal, or Ag alloy or Au alloy containing a very small quantity of at least one of Mg, Ti, Ni and Cu as the additive substance, thereby it is possible to heighten the tension strength for reaching three times.

As a result, the superconducting tape-shaped wire can be constituted for enable to bear the electro-magnetic force and further to not deteriorate the fact in which the metal covering member reacts with the oxide system superconductor.

Further, in the oxide superconducting magnet, as the insulating metal member using the heat-resistance metal such as Cu alloy containing 2-12 % Al, preferably arms bronze or stainless steel, Ti alloy, Fe-base heat-resistance alloy, Ni base heat-resistance alloy, Co base heat-resistance alloy, it is possible to reinforce the superconducting coil by the insulating metal member.

Further, in the manufacture method of the oxide system superconducting magnet, before the coil winding process the insulating metal member is performed to the heat treatment in advance, after the compressive oxide film is formed in the surface on the insulating metal member and after that the coil winding is performed.

As a result, the reaction between the insulating metal member and the oxide system superconductor can be prevented, accordingly the persistent current magnet can be obtained.

In this case, the interior portion of the insulating metal member is maintained at the non-oxidation state, the mechanical strength of the insulating metal member is maintained, and further the strength strong enough against the electro-magnetic force is held.

The necessary electro-magnetic force performance is varied in accordance with the magnetic field strength and the current value etc. generated in the superconducting coil.

These conditions are carried out the design in advance, in case of need, it can devise that the thickness of the insulating layer is formed to have the sufficient large thickness.

However, when the thickness of the insulating layer is excessively thick, it may invite the obstacle for winding the superconducting coil, for example, if case of the employment of arms bronze, in commonly it is desirable to employ arms bronze having the thickness of 30-100 microns.

Further, in the manufacture method of the oxide system superconducting magnet, after the coil winding process, by performing the heat treatment, in the oxide system superconducting tape-shaped wire long enough for practical application, the superconducting wire can be held in the long range without the local mechanical stress, thereby an effect for attaining the persistent current magnet can be obtained.

### Brief Description of Drawings:

Fig. 1 is a view showing a manufacture process of an oxide system superconducting tape-shaped wire according to the present invention;
Fig. 2 is a view showing a cross-sectional structure of a multifilament superconducting tape-shaped wire which is placed the present invention;
Fig. 3 is a view showing a partial melting heat treatment process according to the present invention;
Fig. 4 is a view showing an annealing heat treatment process according to the present invention;
Fig. 5 is a view showing a manufacturing process of an oxide system superconducting tape-shaped wire according to Comparison Example;
Fig. 6 is a view showing current (I) - voltage (V) characteristics according to the present invention and according to Comparison Example;
Fig. 7 is a view showing a relationship between a critical current density (Jc) and a magnetic field dependency (B) of an oxide system superconducting tape-shaped wire according to the present invention and according to Comparison Example;
Fig. 8 is a view showing a relationship between a critical current density (Jc) and a wire length of the oxide system superconducting tape-shaped wire according to the present invention and according to the prior art;
Fig. 9A is a view showing a cross-section of the oxide system superconducting tape-shaped wire according to the present invention;
Fig. 9B is a view showing a cross-section of the oxide system superconducting tape-shaped wire according to Comparison Example which has a sausaging structure;
Fig. 10A is a squint view showing one apparatus for carrying out a compressing process of the oxide system superconducting tape-shaped wire according to the present invention;
Fig. 10B is a side view showing one apparatus for carrying out a compressing process of the oxide system superconducting tape-shaped wire according to the present invention;
Fig. 11 is a view showing another apparatus for carrying out a compressing process of the oxide system superconducting tape-shaped wire according to the present invention;
Fig. 12 is a view showing a further apparatus for carrying out a compressing process of the oxide system superconducting tape-shaped wire according to the present invention;
Fig. 13 is a view showing a concrete construction of a method of preventing a meandering of the oxide system superconducting tape-shaped wire in the apparatus construction shown in Fig. 12;
Fig. 14 is a view showing a relationship of a roll diameter relating to a wire width of the oxide system superconducting tape-shaped wire before the processing and a tape width of the oxide system superconducting tape-shaped wire after the processing;
Fig. 15 is a view showing a relationship of between the critical current density (Jc) and a rate between a wire width (r) of the oxide system superconducting tape-shaped wire before the processing and a wire width (w) of the oxide system superconducting tape-shaped wire after the processing according to the present invention;
Fig. 16 is a view showing a preparation process of a twisted construction oxide system superconducting tape-shaped wire according to the present invention;
Fig. 17 is a view showing a process for carrying out a heat treatment of an oxide system superconducting tape-shaped wire long enough for practical application according to the present invention;
Fig. 18 is a view showing a powder synthesis apparatus for use in the present invention;
Fig. 19 is a view showing a superconducting coil construction according to the present invention;
Fig. 20 is a view showing a bobbin construction of a double pancake-shaped winding superconducting coil;
Fig. 21 is a view showing a cross-sectional construction of a resin immersed 24 stages laminated superconducting coil according to the present invention; and
Fig. 22 is a view showing a superconducting magnet system according to the present invention.

### Description of the Invention:

Hereinafter, various embodiment of an oxide system superconducting tape-shaped wire and a manufacture method of the same according to the present invention will be explained.

### Embodiment 1

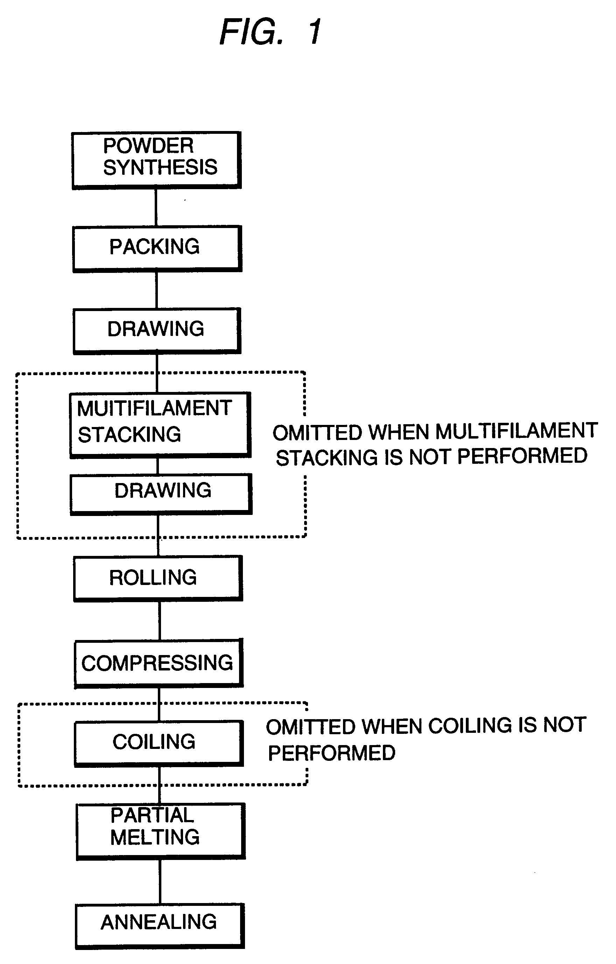

Hereinafter, a manufacture method of an oxide system superconducting tape-shaped wire according to the present invention will be explained referring to Fig. 1.

Fig. 1 is a view showing a detail process of the manufacture method of the oxide system superconducting tape-shaped wire according to the present invention.

After previously synthetic Bi₂Sr₂Ca1₁Cu₂Oₓ powders having a crystal particle size of 1-3 micron were heated during about 1-20 hours and at 800 °C and the powders were rapidly cooled, and the adsorption gas was discharged.

After that the powders were packed up in a silver pipe having an outer diameter of 6 mm, an inner diameter of 5 mm and a length of 800 mm. This powder packing pipe was die-wire-drawing processed down to an outer diameter of 0.9 mm using a drawing bench.

Herein, in a midway of the above process, at an outer diameter of 3.9 mm of the pipe the pipe was annealed at 300 °C and during 10 minutes and at an outer diameter 1.03 mm of the pipe the pipe was heated at 800 °C and during 1-20 hours and after then the pipe was rapidly cooled.

The first heat treatment was performed so as to prevent the snapping of the superconducting wire in the process midway, and the next heat treatment was performed so as to prevent the gas generation in an interior portion of the superconducting wire, thereby the swelling in the superconducting wire can be prevented.

The wire was wire-drawn through a hexagon shape die having a diagonal length of 0.96 mm and a strand wire having a hexagon cross-sectional shape and a length of 15-20 m were obtained.

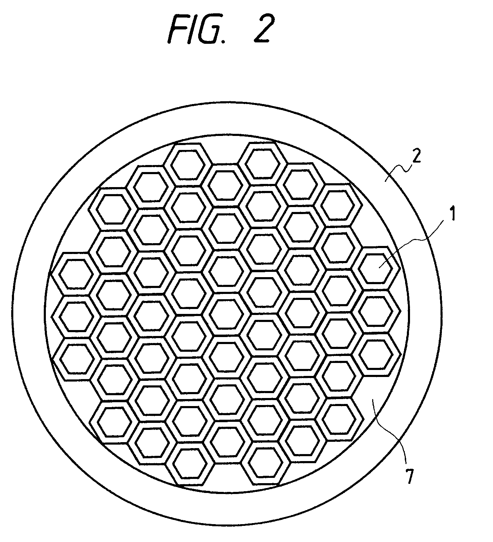

After the strand wire was cut down to have a length of 450 mm, the cut strand wire was assembled into a silver pipe having an outer diameter of 8.2 mm, an inner diameter of 7.1 mm and a length of 520 mm and 55-cores superconducting wire (the multifilament superconducting wire) was obtained as shown in Fig. 2.

This superconducting wire was again wire-drawing processed using a drawing bench and finally the superconducting wire having a diameter of 0.5-2 mm and a length of 10-30 m was obtained.

Herein, in a midway of process, at an outer diameter of 3.9 mm of the pipe the pipe was annealed at 300 °C and during 10 minutes and at an outer diameter 1.62 mm of the pipe the pipe was heated at 800 °C and during 1-10 hours and after then the pipe was rapidly cooled.

The first heat treatment was performed so as to prevent the snapping of the superconducting wire in the process midway, and the next heat treatment was performed so as to prevent the gas generation in an interior portion of the superconducting wire, thereby the swelling in the superconducting wire can be prevented.

When the above stated treatment is neglected, at the final heat treatment the superconducting wire causes the swelling and the problems about the partial wire-braking and the short circuit etc. cause. As a result, it is impossible to prepare the superconducting tape-shaped wire long enough for practical application. Besides, when the final wire diameter of the superconducting wire was more than 1.62 mm, the similar treatment was carried out at the superconducting wire having the final diameter.

Next, when the superconducting wire formed the flat shape, first of all the superconducting wire was processed down to the thickness of 0.2-0.5 mm, a width of 1-3 mm and a length of 5-15 m through a rolling using the rolls.

This process was necessity process for carrying out the multifilament superconducting wire, except for a case of a latter stated twist construction superconducting wire.

When this process is shortened and immediately after a next compressing process is carried out, a non-uniform deformation of each of the oxide cores causes in the wire cross-section, as a result the performance in the oxide system superconducting tape-shaped wire long enough for practical application can not sufficiently attained.

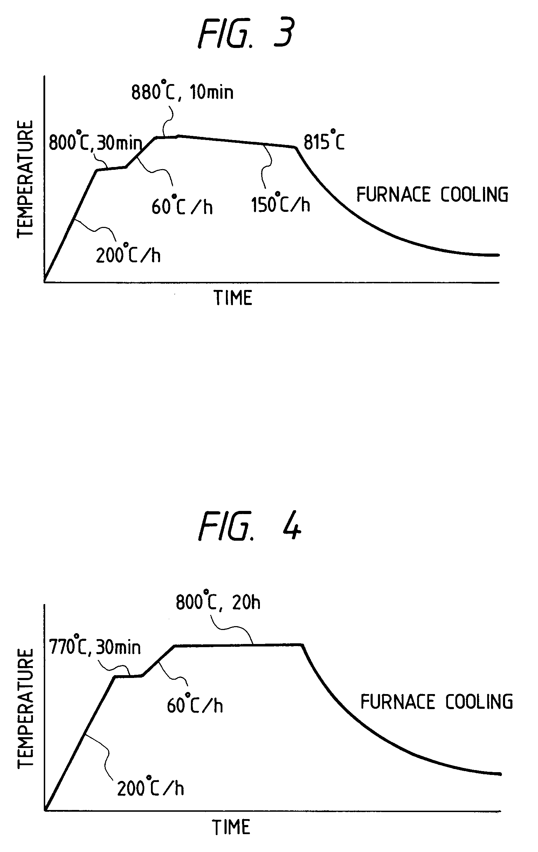

After the above process, when the coil winding was carried out, a pancake-shaped superconducting coil was prepared together with the insulating member. After that the superconducting coil and the insulating member were performed to the partial melting. In Fig. 3, the partial melting heat treatment conditions are illustrated.

The superconducting coil and the insulating member were performed with the treatment under the pure oxygen atmosphere and the pressure of the normal pressure or the pressurized pressure of 4-10 atmospheric pressure. The partial melting heat treatment was performed at the oxygen air flow.

After that, finally under the conditions shown in Fig. 4, the annealing was performed. This annealing in this case was performed at the atmosphere of the nitrogen gas containing 1-20 % oxygen. The contain amount of the oxygen in the above stated case was preferably 5-7 %.

When the oxygen partial pressure is high, it is difficult to obtain the annealing effect. However, when the oxygen partial pressure is low, since the crystal performs to react the composition reaction, it is difficult to obtain the good characteristics in the superconducting wire.

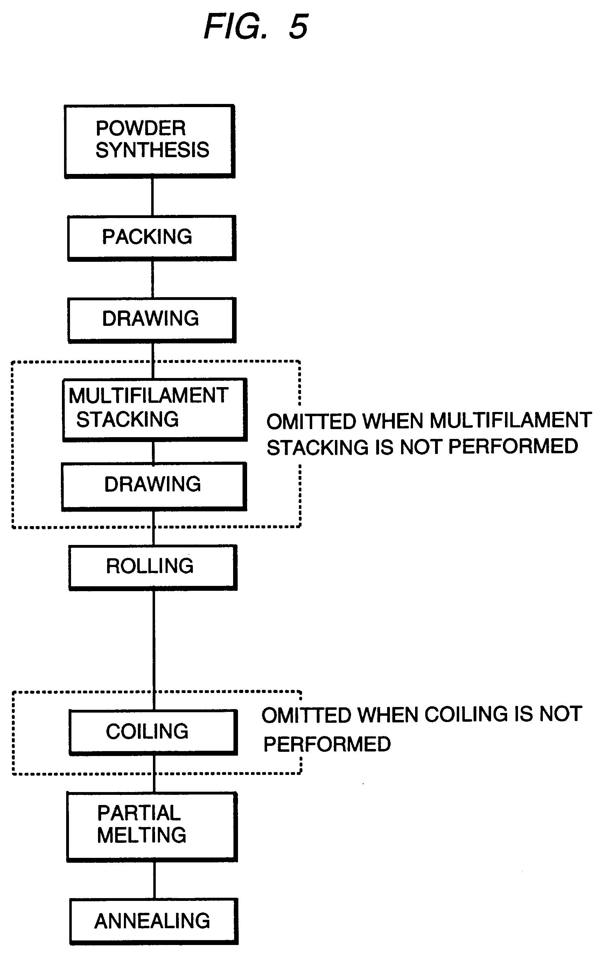

Fig. 5 shows a process view of a manufacture method according to Comparison Example in which the compressing processing is not carried out. The processes except for the compressing process were the same ones shown in Embodiment 1, by the rolling the tape width of the superconducting wire was processed so far as the tape width of the superconducting wire shown in Fig. 1.

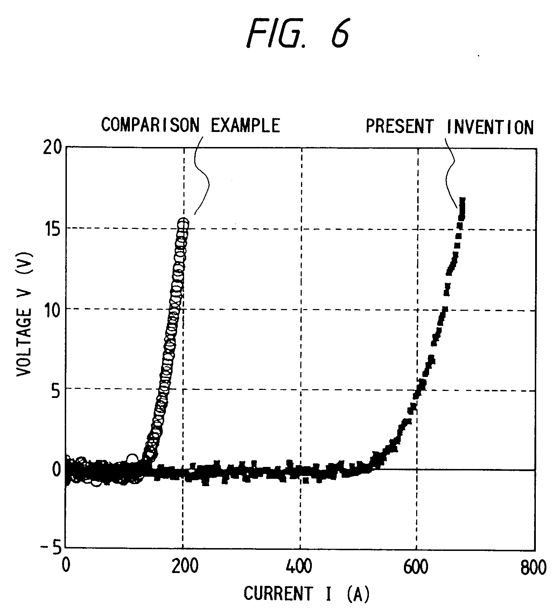

Fig. 6 is the critical current characteristic of the superconducting wire according to the present invention in which an outer diameter 1.52 mm entered to the rolling process of the manufacture process according to the present invention by comparing with the critical current characteristic of the superconducting wire prepared by Comparison Example shown in Fig. 5.

The superconducting wire had a length of 1 m, a width of 5 mm, and a thickness of 0.15 mm. A voltage terminal was set respectively at an inner side within 3 cm from both ends of the superconducting wire and is measured by a four-proves method.

Judging from this figure, in the superconducting wire according to the present invention comparing with that of Comparison Example, it turned out that about three times performance improvement in the critical current characteristic was admitted.

At the size of the width of 5 mm and the thickness of 0.15 mm, it is possible to supply the large current of 550 A. In the critical current density Jc estimated by the whole cross-section area of the superconductor, this above value was a value of 73,000 A/cm².

This obtained value sufficiently exceeded 10,000 A/cm² being set up as the standard in the practical use and the superconducting wire having the above sated large critical current density Jc is consistent with the performance in the critical current density Jc of the short sample superconducting wire.

When the oxide system superconducting tape-shaped wire long enough for practical application is prepared, the processing characteristic of the superconducting wire becomes a problem.

In particularly, when the extremely compressing processing as shown in the present invention is performed, a ratio between the core of the superconducting wire and a metal covering metal becomes important.

According to the present invention, even in a case of the multifilament superconducting wire it found out that the processing of the superconducting wire was possible to perform without the problem when a total thickness at the superconductor portion was more than 20 % but less than 40 % against the total thickness of the superconducting wire.

When the total thickness at the superconductor portion is more than 50 %, the edge cracks generate at an end of the superconducting tape-shaped wire. Further, when the total thickness in the superconductor portion is less than 10 %, an overall critical current density in the superconducting wire can not sufficiently secure.

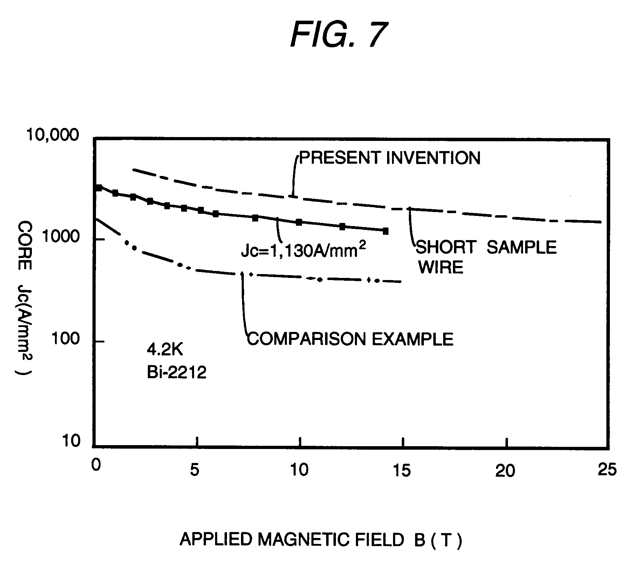

Fig. 7 is a view showing a comparison of the critical current density Jc in the magnetic field of the superconducting wire according to the present invention, according to the short sample superconducting wire and further according to Comparison Example.

As clearly shown from this figure, the performance of the oxide system superconducting tape-shaped wire long enough for practical application according to the present invention can bear in comparison with the performance of the short sample superconducting wire and the superconducting wire according to the present invention has a sufficient performance for the practical use.

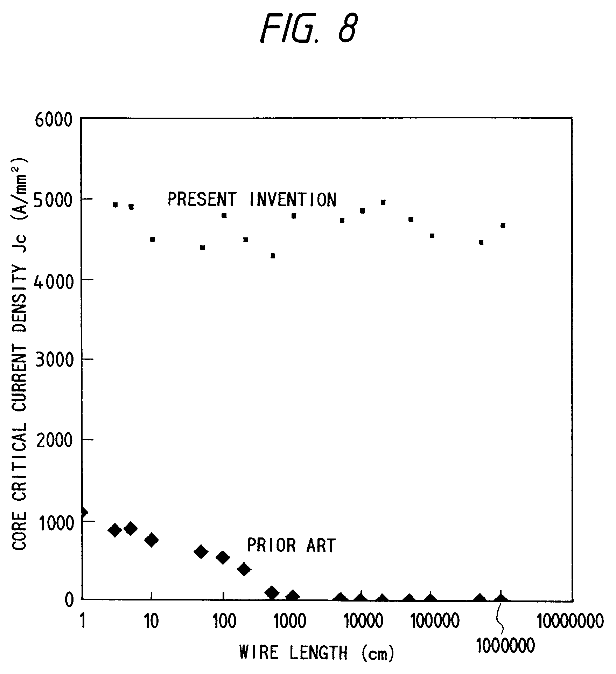

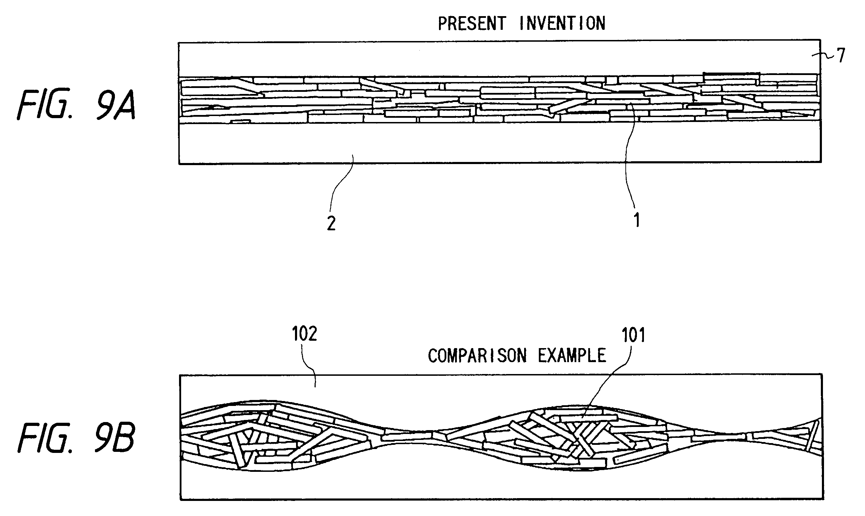

Fig. 8, Fig. 9A and Fig. 9B are views showing results of between the superconducting wires prepared by the manufacture method according to the present invention shown in Fig. 1 and the manufacture method of the Comparison Example shown in Fig. 5.

Fig. 8 is a view showing a relationship between the critical current density Jc and the length of the superconducting wire (the distance between the terminals) in an outside magnetic field at 4.2 K. Herein, the critical current density Jc is defined at a resistance generation point of 10⁻¹³ Ωm. As clearly shown in this figure, the superconducting wire according to the present invention had the performance of about 4-5 times in the single sample in comparison with the superconducting wire according to Comparison Example.

Further, at an area exceeding 10,000 cm, namely 10 m, in the superconducting wire according to the Comparison Example it can not entirely supply the electricity, however in the superconducting wire according to the present invention, an effective effect for attaining the critical current density Jc of about 4,000-5,000 A/mm² can be obtained.

Fig. 9A and Fig. 9B are views showing a shape of the superconducting core in a longitudinal direction cross-section of the superconducting wire according to the present invention and according to Comparison Example. An oxide system superconductor 1 is covered by a metal covering member 2.

Herein, according to the present invention, the smoothness characteristic of a boundary face between the oxide system superconductor core 1 and the metal covering member 2 of an oxide system superconducting tape-shaped wire 7 was substantially maintained in accordance with the compressing processing.

In other words, in the oxide system superconducting tape-shaped wire 7 according to the present invention, the scattering of the superconductors 1 hardly appeared and the boundary face between the superconductors 1 and the metal covering member 2 was maintained at the substantial same circle form in the vertical direction cross-section.

The above stated boundary faces in the longitudinal direction cross-section had the substantial two parallel lines from the start end to the finish end of the superconducting wire 7.

The thickness of the superconductor portion is uniformly maintained and has substantially same thickness along to the vertical direction cross-section maintained and the thickness of the metal covering member 2 was uniformly maintained and has substantially same thickness along to the vertical direction cross-section.

However, the superconducting wire 7 prepared by the method according to Comparison Example, the boundary face between the superconductor 101 and the metal covering member 102 was maintained at the wave form in the vertical direction cross-section.

Thereby, the local constrictions were caused by the wave-form pulsation of the cross-section composition (herein, it is called as "sausaging" structure in the present specification) and the lowering of the critical current was invited.

Further, according to this sausaging structure it was considered that an orientation characteristic of the crystal may lowered and also the critical current density Jc may lower.

In generally, it is known that the sausaging structure easily causes at the direction of the metal deformation when the powder member covered by the metal is processed. In the rolling processing of the superconducting tape-shaped wire, the superconducting wire elongates toward the length direction but does not elongate toward the width direction.

Therefore, the sausaging structure causes in the cross-section of the length direction and the performance at the length direction of the superconducting wire deteriorates.

Besides, in the pressing process, the elongation of the superconducting wire causes toward the width direction but toward the length direction the deformation hardly causes due to the large friction force.

However, in this case, it is difficult to manufacture the oxide system superconducting tape-shaped wire long enough for practical application having more than 1 m and further the sausaging structure causes in the lateral direction cross-section by the width direction elongation.

Besides, in the long size superconductor for practical application, so as to obtain the high critical current density Jc, it is necessary to strictly select the process conditions for reducing the sausaging structure as far as possible.

It was possible to remove the sausaging structure in the superconducting wire according to the process method shown in a following Embodiment 2 practiced by the inventors of this present invention.

### Embodiment 2

Hereinafter, a detail compressing process for removing the sausaging structure in the superconducting wire according to the present invention will be explained referring to Embodiment 2.

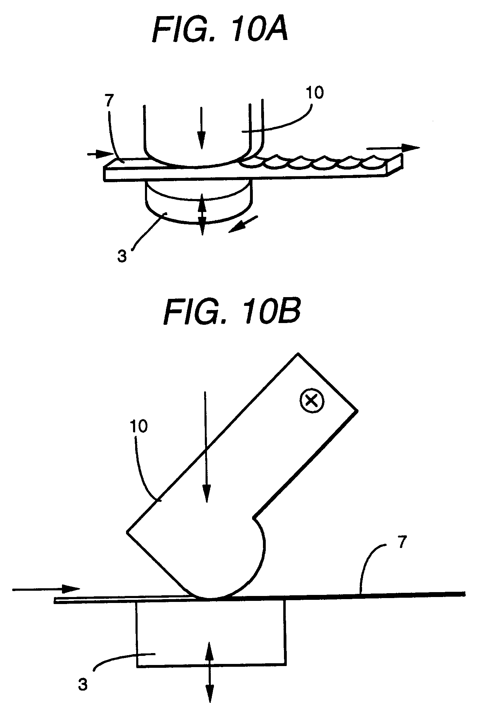

Fig. 10A, Fig. 10B, Fig. 11 and Fig. 12 show schematic construction views of various compressing process apparatuses according to the present invention.

These compressing process apparatuses are basically based on the already known apparatus construction, however as a continuous compressing processing for the long size superconductor for practical application, several important improvements are further added on the compressing process apparatus.

In Fig. 10A and Fig. 10B, this compressing process apparatus is constituted such that an arc face of a tool 10 having an outer projecting arc-shaped face repeatedly presses to the moving superconducting wire 7 and presses the superconducting wire 7 under pressure a flat face of the disk 3 arranged at a lower portion.

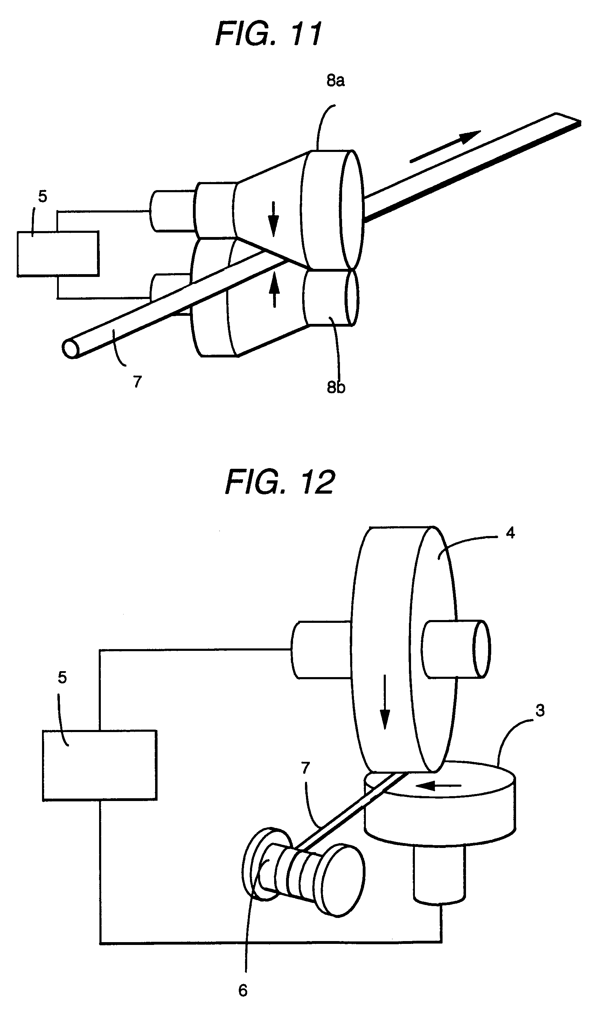

Further, a compressing process construction shown in Fig. 11 is constituted by a pair of rotating rolls 8a and 8b and a processing face of the pair of rolls 8a and 8b for sandwiching the superconducting wire 7 is titled or sloped with a predetermined angle against rotative axis of the pair of rolls 8a and 8b.

In Fig. 12, the compressing process apparatus is constituted that the superconducting wire 7 is continuously inserted between a face of the disk 3 and a face of the roll 4. The above disk 3 is arranged at the lower portion and rotates in a horizontal direction and the above roll 4 is arranged at the upper portion and rotates in a vertical direction.

Herein, taking the case of Fig. 12 as one example, the compressing process apparatus is constituted as following. In this compressing process apparatus, the pressurizing force between the disk 3 and the roll 4 is detected by a load cell 5 and the pressurizing force having 1-2 tons is constantly maintained.

In this compressing process apparatus, in a case that when the pressurizing tool such as a roll do not operated, similarly to a common press processing apparatus, it is possible to give a static pressurizing force.

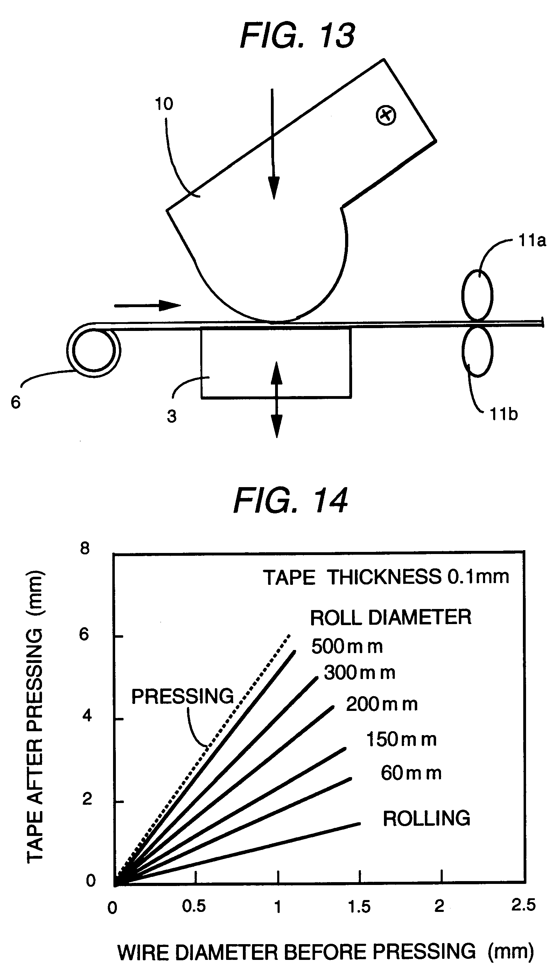

Further, at an outlet side of the superconducting wire 7, as shown in Fig. 13, a tension adjustment means 11 is added so as to restrain the meandering of the superconducting wire 7. In a case of no tension adjustment means, the meandering degree of the superconducting wire 7 was remarkably 3 cm at the maximum per 1 m.

In the conventional rolling, since the above stated meandering of the superconducting wire 7 does not generate, as a result this meandering phenomenon is considered as a remarkable feature according to the present invention. However, in the case that the meandering adjustment operation is carried out, the meandering of the superconducting wire 7 was less than 0.5 mm per 1 m, as a result a problem was not substantially admitted.

In a case that the meandering having more than 1 mm exists on the superconducting tape-shaped wire 7, since the coil winding substantially becomes difficult, thereby the tension adjustment means 11 becomes a necessity addition mechanism.

Further, in Fig. 13 the compressing process apparatus construction shown in Fig. 10A and Fig. 10B is exemplified as one example, however in the compressing process apparatus constructions shown in Fig. 11 and Fig. 12, by arranging a pair of tension rolls 11a and 11b at an outlet side of the superconducting wire 7, the entirely similar meandering restraint effect in the moving superconducting wire 7 will be obtained.

Further, in this compressing process apparatus, the quality of material of the tools such a roll is formed from the hard metal and by paying an attention to the compression effect of the roll or the arc-shaped tool a diameter of the roll (or an arc diameter of the arc-shaped tool) is set more than 200 mm, preferably 250-500 mm.

Fig. 14 is a view showing the studied result by the various diameters of a relationship between the tape width (thickness of 0.5 mm) of the superconducting wire before the processing and the tape width (thickness of 0.1 mm) of the superconducting wire under the condition of the pressurized weight of 2 tons.

Herein, the more the extent toward the width direction of the superconducting wire is large, the more the compressing process easily performed and thereby the large restraint effect of the sausaging structure in the length direction can be obtained.

From the above result, it is preferable to have the large diameter of the roll (the large diameter of the arc-shaped tool) and more preferably the diameter of the roll or the arc-shaped tool is more than 250 mm, and it can understood that the width of the superconducting wire after the processing is substantially saturated.

The reason why the diameter of the roll (the diameter of the arc-shaped tool) is set an upper limit is that the manufacture of the tool becomes difficult and the problem in the working characteristic causes, however it does not the restraint caused from the aspect of the performance.

**Table 1**

| roll diameter (mm) | theoretical density ratio (%) | critical current (A) of wire | sausaging |
|---|---|---|---|
| roll | 89 | 17 | remarkable in length direction |
| 60 | 91 | 153 | a little in length direction |
| 100 | 91 | 215 | non-existence |
| 150 | 93 | 281 | non-existence |
| 200 | 97 | 478 | non-existence |
| 300 | 98 | 550 | non-existence |
| 500 | 98 | 592 | a little in width direction |
| press | 98 | 548 | remarkable in width direction |

In Table 1, the relationships between the diameter of the upper roll, the theoretical density ratio and the critical current of the oxide core of the superconducting wire prepared by the manufacture method shown in Fig. 10.

Hereinafter, taking the case of the process of the superconducting wire stated in Embodiment 1 according to the present invention, a concrete working procedure will be explained.

The superconducting wire 7 having pressed, which is wound up to the wind-up spool 6 in advance, is inserted into between the depressor tools shown in Fig. 10A, Fig. 10B, Fig. 11, or Fig. 12.

After that, paying an attention to the value of the load cell 5, the pressure is gradually applied to the superconducting wire 7, and the force having 3 tons is loaded between the rolls at a total pressure value.

With this condition, first of all, the tension adjustment means 11 is driven, in succession the compressing process apparatus is driven, and the superconducting wire 7 was processed by continuously moving the superconducting wire 7 toward the length direction.

In this case, in the compressing process construction shown in Fig. 10A and Fig. 10B and Fig. 12, the diameter of the roll (the arc-shaped tool) is set 300 mm and the diameter of the lower horizontal plane face roll is set 200 mm.

Further, in the compressing process construction shown in Fig. 11, the maximum diameter and the minimum diameter between the upper and lower rolls 8a and 8b are set 400 mm and 300 mm, respectively.

The width and the thickness of the superconducting tape-shaped wire 7 before the compressing processing are set 2.3 mm and 0.5 mm. A size of the superconducting wire 7 after final process is the width of 5 mm and the thickness of 1.3 mm in both processing methods.

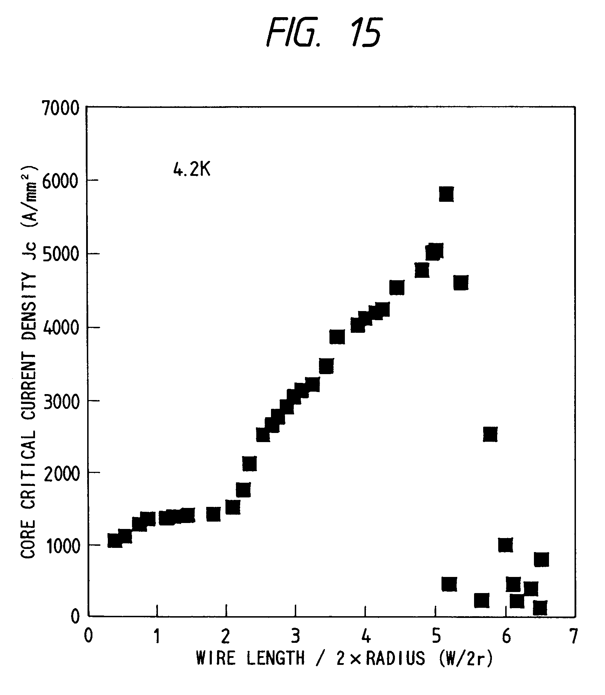

Fig. 15 shows the relationship between the ratio between the radius (r) in the cross-section of the superconducting wire and the width (w) of the superconducting wire after the flat processing and further the critical current density Jc, in the case that the superconducting wire having a circle cross-section shape was processed to the superconducting wire having a flat cross-section shape according to the present invention.

As clearly shown in this figure, it can understood in case that the value or the ratio (w/2r) was more than 3, a remarkable critical current density Jc improvement effect was admitted.

In case that the value or the ratio (w/2r) exceeds 6, the cracks generate at the end portion of the superconducting wire, the melting substance exudes during the heat treatment, thereby the critical current density Jc lowers. When the oxide system superconducting tape-shaped wire long enough for practical application is needed, it can understood that it is desirable to set the upper limit to be 6.

### Embodiment 3

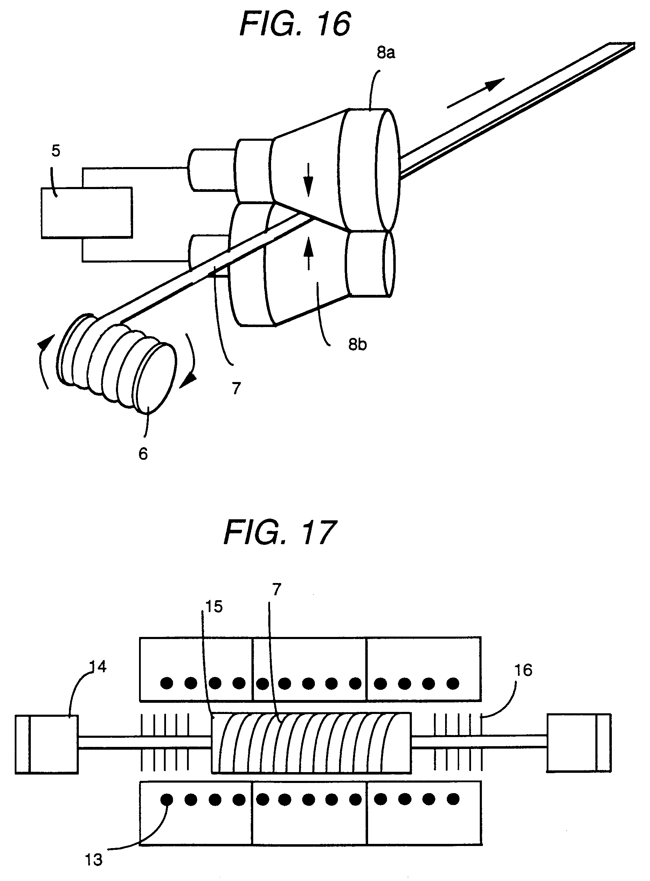

In Fig. 16, by rotating the oxide system superconducting tape-shaped wire 7 having the circle cross-section through the spool 6, the superconducting wire 7 having a twist construction can be continuously obtained. Other constructions of this compressing process apparatus have similar constructions stated on Embodiment 2.

With the above effect, in the twisted construction superconducting wire 7 it is possible to obtain the compressing process and accompanying with this even the compressing process is directly performed from the circle cross-section, it has an effect in which the cross-section shape of the superconducting core is not to form a non-uniform.

The critical current density Jc of this twisted construction superconducting wire 7 is consistent with a range of an error in comparison with a non-twisted construction superconducting wire.

It is possible to voluntary control the twist pitch of the twisted construction superconducting wire 7. However, so as to restrain the twist and the snapping in wire due to an unnatural process distortion (stress), in the compressing process construction shown in Fig. 10A and Fig. 10B and Fig. 12 employing the lower disposed disk 3 at the lower portion, it is desirable to rotate at the speed, this seed is synchronized with a peripheral speed accompanied with the rotation of the disk 3.

The twisted construction superconducting wire 7 prepared by the above was entirely equal to the common metal system superconducting wire, and in accordance with the known theory with respect to the alternative current loss, it is possible to widely reduce the coupling loss etc..

### Embodiment 4

Fig. 17 is a view showing a heat treatment method of the superconductor according to the present invention. In the heat treatment of the oxide superconductor, in comparison with the heat treatment of the common superconductor, a strict temperature management having the temperature error of within 2 °C even the lowest is required.

This becomes hardly a problem in the heat treatment in the superconducting wire long enough for practical application. However, it becomes a problem, in particularly, in case of the preparation of the superconducting wire long enough for practical application or during the heat treatment for a large scale superconducting coil.

Namely, it often generate a problem in which the performance of the superconducting wire or the superconducting coil lowers according to the non-uniformity characteristic of the temperature distribution in an electric furnace, thereby even the process satisfactorily proceeds a sufficient performance does not frequently exhibit.

In the heat treatment apparatus shown in Fig. 17, the above states problems can be solved, it is possible to perform the heat treatment of the superconducting wire 7 long enough for practical application with the temperature error of within 1 °C.

Herein, the oxide system superconducting tape-shaped wire 7 is heated by a ring shape heater 13. In this case, the ring shape heater 13 are divided at least three pieces at a cylinder axial direction of the heater 13. It is desirable to adjust the temperature distribution in the length direction of the electric furnace.

The superconducting wire 7 was wound to a drum 15, which was disposed in the furnace and had a diameter of 30 cm, with 100 turns, namely about 100 m and provided radiation shields 16 at outer sides. The drum 15 operatively rotates 0.2-1 rotation per second through a motor 14. With the above structure, the temperature distribution of a height direction in the furnace can be set off.

As to the atmosphere in the furnace, it is possible to perform the heat treatment at the voluntary conditions, for example a pure oxygen, for example a nitrogen containing 5 % oxygen, etc. in accordance with the shielding of a heat portion by a quartz glass or a stainless steel.

With this heat treatment apparatus, in actually it is possible to perform the heat treatment having the temperature error of 1 °C at the voluntary temperature having a range of 800-900 °C extending over a whole length superconducting wire having the length of 100 m.

As a result, the homogenous superconducting wire 7 as shown in Embodiment 4 according to the present invention can be prepared. Further, by installing the superconducting coil at the position of the drum of this heat treatment apparatus, even an uniformity shape superconducting coil it is possible to do the homogenous heat treatment.

### Embodiment 5

So as to sufficiently secure the homogenous characteristic of the multifilament superconducting wire, it is necessary to homogenize the density distribution of the powders to be packed up and to uniform in the length direction and the cross-section in particularly at the finish time after the processing.

In order to obtain the above, it is effective to form the particle diameter of the crystal to make 1-3 microns. The above stated powders having the particle diameter of 1-3 microns can be obtained a following method. Hereinafter, taking the case of the synthesis Bi_{1.8}Pb_{0.4}Sr_{2.0}Ca_{2.2}Cu_{3.01}Oₓ it will be explained.

First of all, nitrates raw material of each component element was prepared with a predetermined mole ratio. As to nitrate except for nitric acid bismuth, the weight of 100 g totaled each of nitrates was soluble in a pure water of 100 g.

And nitrate bismuth was soluble in nitric acid aqueous of 10 cc in which a rate between the pure water and the dense nitric acid was 1 : 1. These solutions were mixed with a predetermined mole ratio.

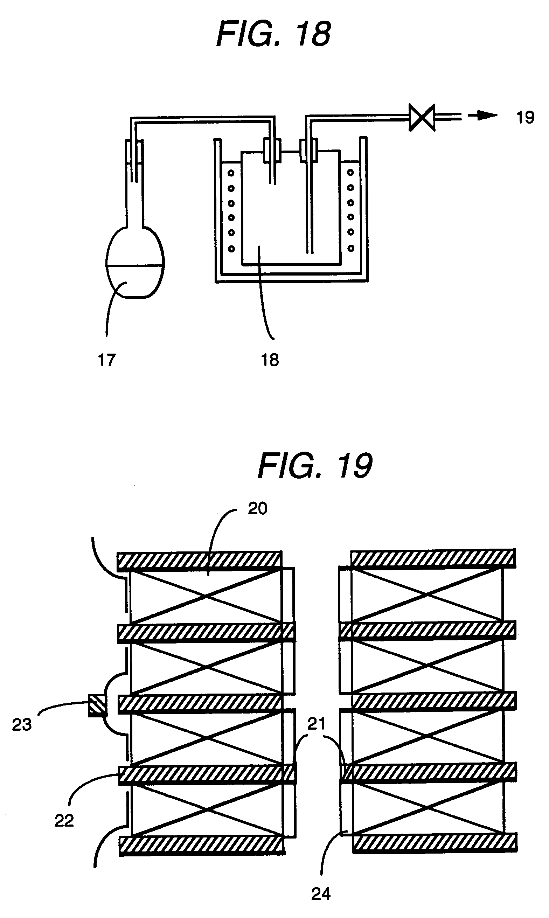

The mixture solution was filled up in a freeze dryer fresco vessel 17 as shown in Fig. 18 with a predetermined mole ratio. By maintaining the vessel 17 in a cold trap 18 at less than -50 °C, preferably -150 - -196 °C, then the fresco vessel 17 was pressure-reduced.

Accordingly, the mixture solution in the fresco vessel 17 was dried at a self-cool solidified condition by a vapor latent heat and the powders mixed in an atomic order was obtained.

These powders was heated under 800-840 °C during 10-100 hours and nitrate was removed, then the oxide superconducting crystal having the particle diameter of 1-3 microns was obtained. However, with the oxide superconducting crystal having the particle diameter of less than 1 micron, it was difficult to pack up into the pipe.

### Embodiment 6

Fig. 19 shows an example of a superconducting coil construction using the superconducting tape-shaped wire according to the present invention. As a pancake-shaped superconducting coil 20, a silver covering 55-cores (multifilament) superconducting tape-shaped wire was used, such a superconducting wire had a thickness of 0.15 mm and a width of 5 mm prepared by the method of Embodiment 1 according to the present invention.

The pancake-shaped superconducting coil 20 had an inner diameter of 30 mm and an outer diameter of 105 mm. As a bobbin 24 of each of the pancake-shaped superconducting coil 20, Si base 1,000 ppm Mg oxide diffusion reinforce alloy was used, such reinforce alloy had an outer diameter of 30 mm and a thickness 2 mm.

In this example shown in Fig. 19, the superconducting coil construction was one which laminated a single pancake with four layers, each of adjacent superconducting coils was wound in a reverse direction and insulated by an aluminum plate 22.

An outer portion connection portion 23 was connected by a soldering by overlapping the upper and the lower pancakes with a half periphery at the most outer periphery and fixed by FRP from an outside so as to reduce the connection resistance. An inner portion connection portion 21 was directly joined between bobbins in the case of single pancake-shaped winding superconducting wire shown in Fig. 19.

Further, in the case of the double pancake-shaped winding superconducting coil, the inner portion connection portion 21 is unnecessary, the pancake being wound at the upper and the lower directions and further in the reverse direction are coiled the same bobbin.

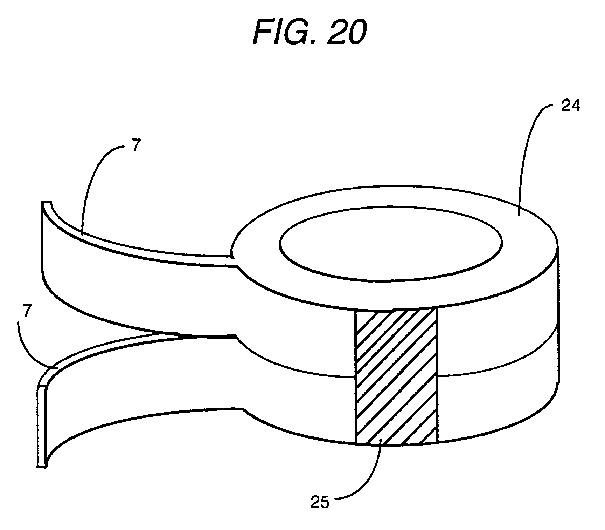

In this case, since the resistance generation causes between the upper and the lower pancakes through the bobbin member, so as to solve this, it was devised that an oxide system superconducting layer 25 was carried out a coating treatment on a surface of the bobbin 24 as shown in Fig. 20.

Further, as the insulating member of this superconducting coil, an alumina paper having a purity degree more than 99 % and alumina cloth can be used. These insulating member is the superior insulating member because that the insulating member do not react with the oxide system superconductor.

On the other hand, the insulating member is inferior to in the mechanical strength, in particularly after the heat treatment, since the mechanical tensile strength is less than 1 kg the electromagnetic-force characteristic comes into question.

The oxide superconducting coil is used as the coil for generating the magnetic field of more than 5 T, by employing a higher strength and high insulating member it is necessary to reinforce the superconducting wire 7. Because that the tensile strength of the oxide system superconducting wire in an annealed pure Ag is 10 kg/mm² degree and even the oxide diffusion reinforcement alloy diffused MgO is 30 kg/mm² to the utmost.

Therefore, it is desirable to reinforce the electromagnetic force added to the superconducting coil through the insulating member. However, in this case, it is desirable to that the insulating member has the insulation characteristic, the tensile strength is more than 40 kg/mm² and during the heat treatment process the superconductor does not make to be inferior, etc..

Within the metals for satisfying the above, the most preferable metal is arms bronze (Cu-Al alloy) system material. Accordingly, the arms bronze was the tape shape having a thickness of 70 microns, a width of 3-5 mm and a length of 100 m and was used as the insulating member.

In this time, preferably before the coil winding of the superconducting wire in advance, it is more effective to carry out the heat treatment for forming the minute oxide covering film on the surface of the insulating tape member.

However, the previous oxidation processing is not carried out, after the coil winging, when the heat treatment is carried out in the pure oxygen at more than 800 C, such a metal can utilize. Further, in the heat resistance metal material, when the oxidation covering film is formed on the surface in advance, such a metal can utilize.

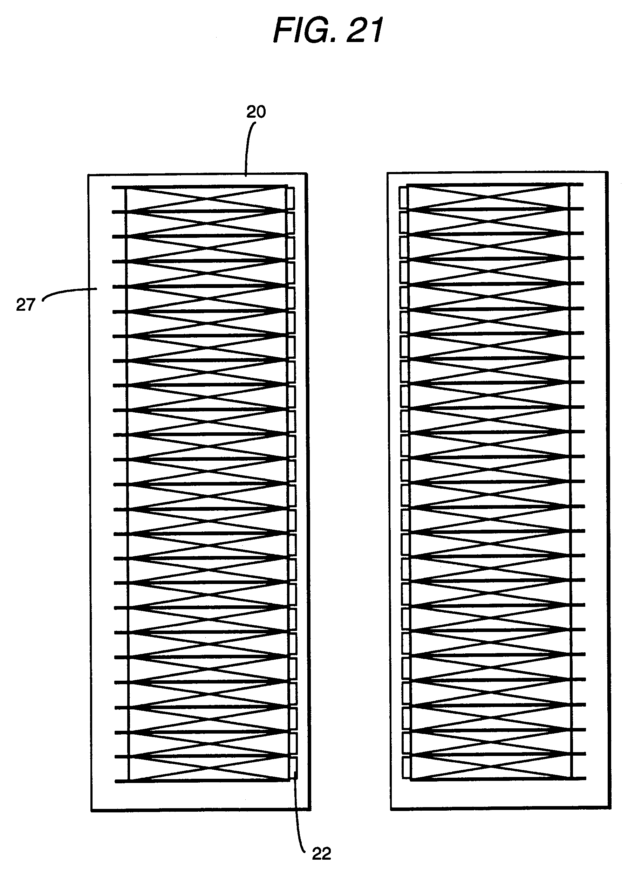

Fig. 21 is a view showing a cross-sectional construction of one example in which 24 stages pancake-shaped superconducting coil was laminated similarly to that of shown in Fig. 19. A whole laminated superconducting coil was immersed by an epoxy resin member 27. The superconducting coil had a size constituting an inner diameter of 30 mm, an outer diameter of 110 mm and a height of 120 mm.

### Embodiment 7

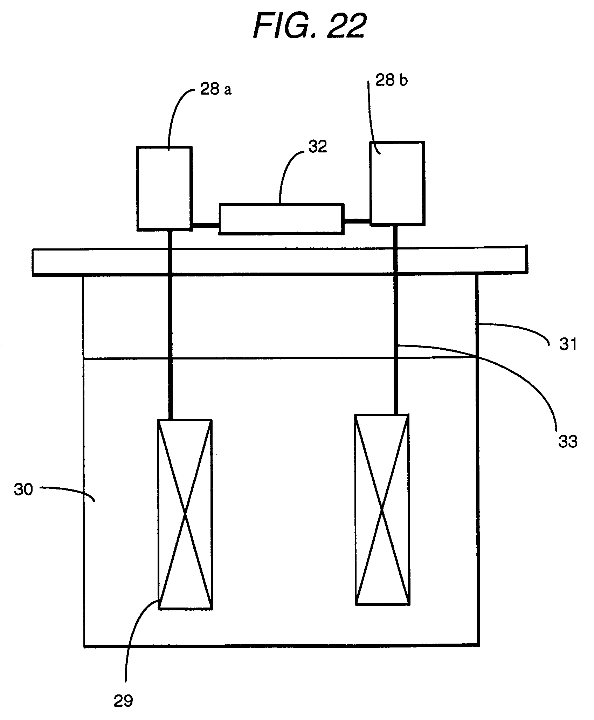

Fig. 22 shows a construction of a superconducting magnet according to the present invention. As a superconducting magnet 29, the oxide system superconducting magnet shown in Embodiment 6 was employed. The superconducting magnet 29 was installed in a cryostat 31 and was cooled by the liquid helium 30. A persistent current switch 32 was connected to the superconducting magnet 29 through copper electrodes 28a and 28b and a current lead 33.

In the above construction, the critical current was 2,000 A defined by the current value in which the resistance of 10⁻¹³ Ω m was generated at both ends of the superconducting magnet 29 and the generation field in the superconducting magnet 29 in this time was 5.8 T. Further, in this state when the apparatus was transferred to the persistent current operation, the magnetic field having 3.4 T was held during 140 hours.

Herein, the oxide system superconducting current lead is used as the current lead 33, an effect for reducing the heat entry to the system, further it is possible to restrain the attenuation of the persistent current due to the resistance. Further, when the oxide system superconductor is used as the persistent current switch 32, it has a merit in which a simple system being cooled by the liquid nitrogen can be constituted.

As stated in the above, the contents are explained, on a basis of one embodiment according to the present invention. The applications of the present invention can be widely adopted to the application field related to superconductivity.

Such application field are a high magnetic field generation magnet, a NMR apparatus, a MRI apparatus for use in a medical treatment, an accelerator, a superconducting magnetic floating train, a SMES, a current limiting device, a superconducting magnet for use in a physics and chemistry, a current lead and a superconducting cable etc..

As stated in the above, as the effects obtained according to the present invention, it is possible to heighten the performances of the oxide system superconducting tape-shaped wire long enough for practical application of the oxide system superconductor equally those of the short sample superconducting wire.

Thereby, the performances in the oxide system superconducting tape-shaped wire enable to put the practice can be realized and an remarkable effect for enabling to realize the magnetic field generation having more than 5 T can be obtained.

## Claims

1. In an oxide system superconducting tape-shaped wire having a flat cross-sectional shape oxide system superconductor and a metal covering member for covering said oxide system superconductor,
the oxide system superconducting tape-shaped wire (7) wherein
in a longitudinal direction cross-section and in a vertical direction cross-section after a compressing process of said oxide system superconducting tape-shaped wire (7), a boundary face of said metal covering member (2) and said oxide system superconductor (1) is formed substantially flat; and
a density of said oxide system superconductor (1) is more than 90 % of a theoretical density.

2. An oxide system superconducting tape-shaped wire according to claim 1, wherein
said oxide system superconducting tape-shaped wire (7) is a flat shape and comprises plural superconductors (1);
each of said plural superconductors (1) disposed in a cross-section of said oxide system superconducting tape-shaped wire (7) is covered by said metal covering member (2); and
a total thickness of said plural superconductors (1) is more than 20 % but less than 40 % of a total thickness of said oxide system superconducting tape-shaped wire (7).

3. An oxide system superconducting tape-shaped wire according to claim 1, wherein
said oxide system superconductor (1) comprises at least one selected from groups of Bi system superconductor and Tl system superconductor.

4. An oxide system superconducting tape-shaped wire according to claim 1, wherein
said metal covering member (2) is at least one selected from the groups of Ag, Cu, an alloy comprised of a base member formed by one kind or two kinds of Ag and Au, and Ag alloy or Au alloy containing a very small quantity of Mg, Ti, Ni and Cu as an additive substance.

5. A method of manufacturing an oxide system superconducting tape-shaped wire comprises the steps of:
a step of wire process for processing an oxide system superconducting tape-shaped wire (7) having a flat cross-sectional shape and covered by a metal member (2);
a step of compressing process for compressing said oxide system superconducting tape-shaped wire (7) after said wire process step to have a theoretical density of more than 90 %; and
a step of partial melting process for partial melting said oxide system superconducting tape-shaped wire (7) after said compressing process step.

6. A method of manufacturing an oxide system superconducting tape-shaped wire comprises the steps of:
a step of wire process for processing an oxide system superconducting tape-shaped wire (7) having a flat cross-sectional shape and covered by a metal member (2);
a step of compressing process for compressing said oxide system superconducting tape-shaped wire (7) after said wire process step to have a theoretical density of more than 90 %;
a step of partial melting process for partial melting said oxide system superconducting tape-shaped wire (7) after said compressing process step; and
a step of heat treating process for performing heat treatment after said partial melting process step.

7. A method of manufacturing an oxide system superconducting tape-shaped wire according to any one of claim 5 or claim 6, wherein
in said compressing process step,
a drawing processing apparatus is employed,
said drawing processing apparatus comprises a rotating disk (3) which is disposed toward a lower portion and rotates in a horizontal direction, and an upper roll (4) which is disposed toward an upper portion and rotates in a vertical direction, and
a diameter of said upper roll (4) is more than of 200 mm,
the method of manufacturing the oxide system superconducting tape-shaped wire comprises further:
a step of continuously inserting said oxide system superconducting tape-shaped wire (7) into between a horizontal face of said disk (3) and a face of said upper roll (4); and
a step of statically pressurizing, between said upper roll (4) and said disk (3), under a pressurizing force of more than 1 ton against a vertical axis.

8. A method of manufacture an oxide system superconducting tape-shaped wire according to any one of claim 5 or claim 6, wherein
in said compressing process step,
a drawing process apparatus is employed,
said drawing process apparatus comprises a pair of rotative shafts disposed in parallel, and a pair of rolls (8a,8b) rotatively with said pair of rotative shafts,
said pair of rolls (8a,8b) comprise an upper portion roll (8a) and a lower portion roll (8b), and
the minimum portion of each of a diameter of said upper portion roll (8a) and said lower portion roll (8b) is more than 200 mm,
the method of manufacturing the oxide system superconducting tape-shaped wire (7) comprises further:
a step of tilting process faces of said pair of rolls (8a,8b) for sandwiching said superconducting tape-shaped wire (7) by said pair of rolls (8a,8b) with a predetermined angle against said rotative shafts; and
a pressurizing said superconducting tape-shaped wire (7), between said upper portion roll (8a) and said lower portion roll (8b), under a pressurize force having more than 1 ton against a vertical axis.

9. A method of manufacturing an oxide system superconducting tape-shaped wire according to any one of claim 5 or claim 6, wherein
in said compressing process step,
a drawing process apparatus is employed,
said drawing process apparatus comprises an arc-shaped depressor tool (10) disposed at an upper portion and having an outside projected arc-shaped face, and another tool (3) oppositely disposed against said arc-shaped depressor tool (10) and having a flat face, and
a diameter of an arc of said arc-shaped face of said arc-shaped depressor tool (10) is more than 200 mm,
the method of manufacturing the oxide system superconducting tape-shaped wire (7) comprises further:
a step of repeatedly depressing a moving superconducting tape-shaped wire (7) by said arc-shaped face of said arc-shaped depressor tool (10); and
a step of continuously pressurizing under a pressurize force having more than 1 ton against a vertical axis by said arc-shaped depressor tool (10).

10. A method of manufacturing an oxide system superconducting tape-shaped wire according to any one of from claim 5 to claim 9, wherein
said compressing process step includes further:
a step of a scale-constructing process for carrying out said superconducting tape-shaped wire (7) from a wire having a circle cross-sectional shape to a wire having a smaller radius (r); and
a step of a process for processing said superconducting tape-shaped wire (7) to form a flat shape having a width (w),
thereby the ratio (w/2r) is more than 3 but less than 6.

11. A method of manufacturing an oxide system superconducting tape-shaped wire according to any one of claims 8, 9 or 10, wherein
any one of materials of said disk (3), said roll (8a,8b) and said arc-shaped depressor tool (10) comprises of a hard metal alloy.

12. A method of manufacturing an oxide system superconducting tape-shaped wire according to any one of claims 8, 9 or 10, wherein
said compressing process step includes further:
a step of adding a tension to an outlet side of said superconducting tape-shaped wire (7) being continuously discharged,
thereby the meandering of said superconducting tape-shaped wire (7) is restrained.

13. A method of manufacturing an oxide system superconducting tape-shaped wire according to any one of claims 8, 9 or 10, wherein
said superconducting tape-shaped wire (7) is a multifilament superconducting wire having a circle cross-section;
the method of manufacturing the oxide system superconducting tape-shaped wire comprises further:
said compressing process step includes further:
a step of continuously inserting said superconducting tape-shaped wire (7) at an inlet side of said superconducting tape-shaped wire, and
a step of rotating said superconducting tape-shaped wire (7),
thereby said superconducting tape-shaped wire (7) having a flat cross-section is performed to form a twist structure superconducting wire.

14. A method of manufacturing an oxide system superconducting tape-shaped wire according to any one of claims 8, 9 or 10, wherein
said compressing process step includes further:
a step of suitably rapidly cooling said superconducting tape-shaped wire (7), during said superconducting tape-shaped wire (7) having a circle cross-section, after heat treatment during approximately more than 1 hour and at about 800 °C,
thereby the swelling of said superconducting tape-shaped wire (7) caused due to the gas generation in a final heat treatment after a flat cross-section shaping process step is prevented.

15. A method of manufacturing an oxide system superconducting tape-shaped wire according to any one of claims 8, 9 or 10, wherein
after said partial melting process step, heat treatment is performed under conditions of a mixture gas atmosphere of 1-10 % oxygen and nitrogen or an inert gas, at 400-900 °C and during 1-300 hours.

16. A method of manufacturing an oxide system superconducting tape-shaped wire according to any one of claims 8, 9 or 10, wherein
after said partial melting process step or after said heat treatment process step, an error in temperature during said heat treatment is less than 1 C.

17. A method of manufacturing an oxide system superconducting tape-shaped wire of a multifilament superconducting wire in which each of plural superconductors (1) disposed in a cross-section of a flat-shaped oxide system superconducting tape-shaped wire (7) is covered by a metal member (2), wherein
a particle size of a powder crystal for packing into a metal pipe is 1-3 microns.

18. An oxide system superconducting magnet (29) having an oxide system superconducting tape-shaped wire (7) and an insulating tape-shaped wire being wound with a coil form and a persistent current switch, wherein
electric resistances at both sides of said superconducting magnet (29) are constituted to be low enough for functioning as a persistent current switch.

19. An oxide system superconducting magnet (29) having an oxide system superconducting tape-shaped wire (7) and an insulating tape-shaped wire being wound with a coil form and a persistent current switch, wherein
the generation magnetic field of said superconducting magnet (29) is more than 5.8 T.

20. An oxide system superconducting magnet (29) having an oxide system superconducting tape-shaped wire (7) and an insulating tape-shaped wire being wound with a coil form and a persistent current switch, wherein
the mechanical strength of said insulating tape-shaped wire has the strength enough for functioning as a reinforcement member in comparison with the strength of said superconducting tape-shaped wire (7).

21. An oxide system superconducting magnet according to any one of claim 18 and claim 20, wherein
material for said insulating tape-shaped wire is selected one kind or more than two kinds from groups of Cu alloy containing 2-12 % Al, stainless steel, Ti alloy, Fe base heat-resistance alloy, Ni base heat-resistance alloy, Co base heat-resistance alloy.
